(19) Europäisches Patentamt
European Patent Office
Office européen des brevets

(11) **EP 4 663 700 A1**

(12) **EUROPEAN PATENT APPLICATION**
published in accordance with Art. 153(4) EPC

(43) Date of publication:
**17.12.2025 Bulletin 2025/51**

(21) Application number: **25763726.4**

(22) Date of filing: **22.04.2025**

(51) International Patent Classification (IPC):
***C08L 27/12*** (2006.01) ***C08J 5/18*** (2006.01)
***C08K 3/36*** (2006.01) ***C08K 7/00*** (2006.01)
***C08K 7/04*** (2006.01) ***C08L 27/18*** (2006.01)
***H05K 1/03*** (2006.01)

(86) International application number:
**PCT/JP2025/015625**

(87) International publication number:
**WO 2025/225622 (30.10.2025 Gazette 2025/44)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **24.04.2024 JP 2024070591**

(71) Applicants:
- **Daikin Industries, Ltd.**
  **Osaka-shi, Osaka 530-0001 (JP)**
- **The University of Tokyo**
  **Bunkyo-ku,**
  **Tokyo 113-8654 (JP)**

(72) Inventors:
- **YOSHIZAKI, Satoru**
  **Osaka-Shi Osaka 5300001 (JP)**
- **MIZUTANI, Seigo**
  **Osaka-Shi Osaka 5300001 (JP)**
- **TANAKA, Yoshito**
  **Osaka-Shi Osaka 5300001 (JP)**
- **SEKI, Toyomitsu**
  **Osaka-Shi Osaka 5300001 (JP)**
- **HIGASHI, Masahiro**
  **Osaka-Shi Osaka 5300001 (JP)**
- **KISHIKAWA, Yosuke**
  **Osaka-Shi Osaka 5300001 (JP)**
- **SHIGEMOTO, Isamu**
  **Osaka-Shi Osaka 5300001 (JP)**
- **SAGISAKA, Shigehito**
  **Osaka-Shi Osaka 5300001 (JP)**
- **KIKUCHI, Nozomi**
  **Osaka-Shi Osaka 5300001 (JP)**
- **SHIOMI, Junichiro**
  **Tokyo 1138654 (JP)**
- **XU, Bin**
  **Tokyo 1138654 (JP)**

(74) Representative: **Hoffmann Eitle**
**Patent- und Rechtsanwälte PartmbB**
**Arabellastraße 30**
**81925 München (DE)**

(54) **SOLID COMPOSITION, CIRCUIT BOARD, METHOD FOR PRODUCING SOLID COMPOSITION, AND PROPOSAL DEVICE**

(57) A solid composition containing a fluororesin and an anisotropic filler having a fibrous shape, wherein a reduction ratio of a linear expansion coefficient of the solid composition at 20°C to 200°C to a linear expansion coefficient of the fluororesin at 20°C to 200°C is 50% or greater.

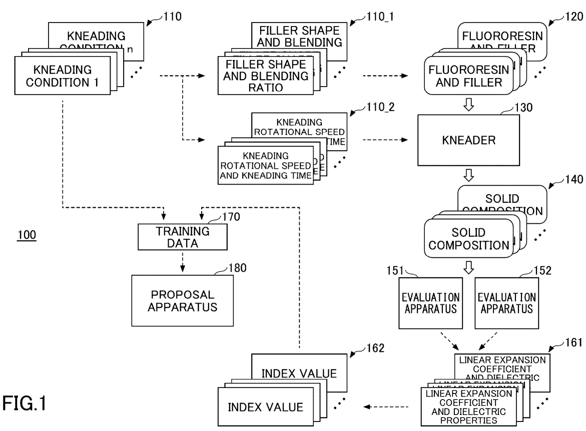

FIG.1

EP 4 663 700 A1

## Description

### TECHNICAL FIELD

The present disclosure relates to a solid composition, a circuit board, a method of manufacturing a solid composition, and a proposal apparatus.

### BACKGROUND ART

As a material for high-frequency boards, fluororesin-and-filler-containing solid compositions that achieve both a low loss tangent and a low linear expansion coefficient have been investigated (see, e.g., PTL 1).

Dispersion liquids containing a tetrafluoroethylene-based polymer powder, an anisotropic filler, and a liquid dispersion medium have been reported (see, e.g., PTL 2).

However, a low dielectric constant and a low linear expansion coefficient are generally in a trade-off relationship, and it is difficult to achieve both of them. No solid compositions for high-frequency board materials that achieve both of a low dielectric constant and a low linear expansion coefficient have been found.

### CITATION LIST

### PATENT LITERATURE

PTL 1: Japanese Patent Application Laid-Open Publication No. 2023-155181
PTL 2: International Publication No. WO 2021/112164

### TECHNICAL PROBLEM

An object of the present disclosure is to provide a solid composition that achieves both a low dielectric constant and a low linear expansion coefficient.

### SOLUTION TO THE PROBLEM

<1> A solid composition including a fluororesin and an anisotropic filler having a fibrous shape,
wherein a reduction ratio of a linear expansion coefficient of the solid composition at 20°C to 200°C to a linear expansion coefficient of the fluororesin at 20°C to 200°C is 50% or greater.
<2> The solid composition according to <1>,
wherein an aspect ratio of the anisotropic filler having the fibrous shape is 100 or greater.
<3> The solid composition according to <1> or <2>,
wherein a mass ratio (A/B) of the anisotropic filler (A) having the fibrous shape to the fluororesin (B) is 5/95 to 60/40.
<4> The solid composition according to any one of <1> to <3>,
wherein the anisotropic filler having the fibrous shape is silica.
<5> The solid composition according to any one of <1> to <4>,

wherein unstable end groups present at an end of a main chain of the fluororesin are less than 50 groups per $1\times10^6$ carbon atoms of the fluororesin, and
the unstable end groups are at least one type selected from the group consisting of $-CF_2H$, -COF, -COOH, $-COOCH_3$, $-CONH_2$, and $-CH_2OH$.

<6> The solid composition according to any one of <1> to <5>,
wherein the fluororesin is at least one type selected from the group consisting of polytetrafluoroethylene, tetrafluoroethylene/perfluoro (alkyl vinyl ether) copolymer, and tetrafluoroethylene/hexafluoropropylene copolymer.
<7> The solid composition according to any one of <1> to <6>,
wherein a loss tangent of the solid composition at 25°C at 10 GHz is 0.003 or less.
<8> The solid composition according to any one of <1> to <7>,
wherein the solid composition is a film or a sheet.

<9> The solid composition according to any one of <1> to <8>,
wherein the solid composition is an insulating material for a circuit board.
<10> The solid composition according to any one of <1> to <9>,
wherein a relative permittivity of the solid composition at 25°C at 10 GHz is 2.6 or less.
<11> A circuit board, including:

an insulating layer containing the solid composition of any one of <1> to <10>; and
a conductive layer.

<12> The circuit board according to <11>,
wherein the conductive layer is a metal.
<13> The circuit board according to <12>,
wherein the metal is copper.
<14> The circuit board according to any one of <11> to <13>,
wherein a surface roughness Rz of a surface of the conductive layer on a side of the solid composition is 2.0 μm or less.
<15> The circuit board according to any one of <11> to <14>,
wherein the circuit board is a printed circuit board, a laminated circuit board, or a high-frequency board.
<16> A method of manufacturing the solid composition of any one of <1> to <10>, the method including:
melt-kneading the fluororesin and the anisotropic filler to obtain the solid composition.
<17> A proposal apparatus, including:

a controller configured to propose a kneading condition for manufacturing a solid composition containing a fluororesin and a filler,
wherein the controller is configured to:

input the kneading condition for search into a trained model trained by using training data including the kneading condition for training and an index value related to a linear expansion coefficient and a dielectric property of the solid composition manufactured under the kneading condition for training, to thereby output a predicted index value; and
optimize the kneading condition for search based on the predicted index value and a target index value, and output the kneading condition optimized.

<18> The proposal apparatus according to <17>,
wherein the kneading condition includes information indicating a shape of the filler and information related to a blending ratio of the fluororesin and the filler.
<19> The proposal apparatus according to <18>,
wherein the kneading condition includes a kneading rotational speed and a kneading time.
<20> The proposal apparatus according to <18> or <19>,
wherein the information indicating the shape of the filler includes information indicating the shape of the filler that is a fibrous shape, information indicating the shape of the filler that is a spherical shape, and information indicating the shape of the filler that is a plate-like shape.
<21> The proposal apparatus according to any one of <18> to <20>,
wherein the information related to the blending ratio includes a mass of the filler having a fibrous shape, a mass of the filler having a spherical shape, and a mass of the filler having a plate-like shape, relative to a predetermined mass of the fluororesin.

ADVANTAGEOUS EFFECTS OF THE INVENTION

According to the present disclosure, it is possible to provide a solid composition that achieves both a low dielectric constant and a low linear expansion coefficient.

BRIEF DESCRIPTION OF THE DRAWINGS

[FIG. 1] FIG. 1 is a diagram showing an example of a system configuration of a processing system including a proposal apparatus in a training phase.
[FIG. 2] FIG. 2 is a diagram showing an example of a hardware configuration of the proposal apparatus.

[FIG. 3] FIG. 3 is a diagram showing an example of training data.
[FIG. 4] FIG. 4 is a diagram showing details of an index value calculation method.
[FIG. 5] FIG. 5 is a diagram showing an example of a functional configuration of the proposal apparatus in the training phase.
[FIG. 6] FIG. 6 is an example of a flowchart showing the flow of processing in the training phase of the processing system.
[FIG. 7] FIG. 7 is a diagram showing an example of a system configuration of the processing system including the proposal apparatus in a proposal phase.
[FIG. 8] FIG. 8 is a diagram showing an example of a functional configuration of the proposal apparatus in the proposal phase.
[FIG. 9] FIG. 9 is an example of a flowchart showing the flow of processing in the proposal phase of the processing system.

DETAILED DESCRIPTION OF THE INVENTION

(Solid Composition)

The solid composition of the present disclosure contains a fluororesin and a fibrous anisotropic filler, and contains other components as needed.

The reduction ratio of the linear expansion coefficient of the solid composition at 20°C to 200°C to the linear expansion coefficient of the fluororesin at 20°C to 200°C is 50% or greater.

By containing the fibrous anisotropic filler, the solid composition of the present disclosure can have a reduced (improved) linear expansion coefficient although it contains the fluororesin, can achieve both of a low dielectric constant of 2.5 or less and a low linear expansion coefficient of 50 ppm/°C or less, and can have a better insulation property and a better moldability.

Further, with the fibrous anisotropic filler blended, the solid composition of the present disclosure includes less voids inside when pelletized. Consequently, the mechanical properties of a film or sheet formed from a pellet are improved. Furthermore, by blending the fibrous anisotropic filler, it is possible to improve the electrical properties.

In addition, because of being a solid, the solid composition of the present disclosure has the advantage that it is manufactured through fewer steps and formation into a thick film is easier, as compared with the dispersion liquid described in PTL 2.

<Fluororesin>

The fluororesin is not particularly limited and can be selected appropriately according to the purpose. However, at least one type selected from the group consisting of polytetrafluoroethylene, tetrafluoroethylene/perfluoro(alkyl vinyl ether) copolymer, and tetrafluoroethylene/hexafluoropropylene copolymer is preferable in that deformation of the solid composition can be reduced and the linear expansion coefficient can be reduced, and tetrafluoroethylene/perfluoro(alkyl vinyl ether) copolymer is more preferable in that deformation of the solid composition during soldering can be reduced. One of these may be used alone or two or more may be used in combination.

The fluororesin is a fluororesin having very few hydrogen atoms that are bonded to carbon atoms in a repeating unit constituting the main chain, and may have hydrogen atoms that are bonded to carbon atoms anywhere, such as a terminal structure and the like, other than the repeating unit constituting the main chain.

Copolymerization with any other copolymerizable monomer is possible as long as the content of fluorine-containing monomers in the fluororesin is 90 mol% or greater, preferably 95 mol% or greater, and yet more preferably 99 mol% or greater. The content of fluorine-containing monomers in the fluororesin may be 100 mol%.

-Perfluoro(Alkyl Vinyl Ether)-

Examples of the perfluoro(alkyl vinyl ether), which is a copolymerized monomer in the tetrafluoroethylene/perfluoro(alkyl vinyl ether) copolymerization, include a fluoromonomer represented by a general formula (10) below, a fluoromonomer represented by a general formula (20) below, a fluoromonomer represented by a general formula (30) below, a fluoromonomer represented by a general formula (40) below, and a fluoromonomer represented by a general formula (50) below.

One of these may be used alone, or two or more may be used in combination.

General formula (10): $CF_2=CF\text{-}ORf^{11}$

(In the formula, $Rf^{11}$ represents a perfluoro organic group.)

General formula (20): $CF_2=CF-OCH_2-Rf^{21}$

(In the formula, $Rf^{21}$ represents a perfluoroalkyl group having 1 to 5 carbon atoms.)

General formula (30): $CF_2=CFOCF_2ORf^{31}$

(In the formula, $Rf^{31}$ represents a linear or branched perfluoroalkyl group having 1 to 6 carbon atoms, a cyclic perfluoroalkyl group having 5 to 6 carbon atoms, or a linear or branched perfluorooxyalkyl group having 2 to 6 carbon atoms and containing 1 to 3 oxygen atoms.)

General formula (40): $CF_2=CFO(CF_2CF(Y^{41})O)_m(CF_2)_nF$

(In the formula, $Y^{41}$ represents a fluorine atom or a trifluoromethyl group, m represents an integer of 1 to 4, and n represents an integer of 1 to 4.)

General formula (50): $CF_2=CF-O-(CF_2CFY^{51}-O)_n-(CFY^{52})_m-A^{51}$

(In the formula, $Y^{51}$ represents a fluorine atom, a chlorine atom, a $-SO_2F$ group, or a perfluoroalkyl group. The perfluoroalkyl group may contain an etheric oxygen and a $-SO_2F$ group. n represents an integer of 0 to 3. The n $Y^{151}$s may be the same or different. $Y^{52}$ represents a fluorine atom, a chlorine atom, or a $-SO_2F$ group. m represents an integer of 1 to 5. The m $Y^{52}$s may be the same or different. $A^{51}$ represents $-SO_2X^{51}$, $-COZ^{51}$, or $-POZ^{52}Z^{53}$. $X^{51}$ represents F, Cl, Br, I, $-OR^{51}$, or $-NR^{52}R^{53}$. $Z^{51}$, $Z^{52}$, and $Z^{53}$ each independently represent $-NR^{54}R^{55}$ or $-OR^{56}$. $R^{51}$, $R^{52}$, $R^{53}$, $R^{54}$, $R^{55}$, and $R^{56}$ each independently represent an alkyl group, an aryl group, or a sulfonyl-containing group that may contain H, ammonium, an alkali metal, or a fluorine atom.)

The term "perfluoro organic group" here means an organic group in which all hydrogen atoms that are bonded to carbon atoms are replaced by fluorine atoms. The perfluoro organic group may contain etheric oxygen and a $-SO_2F$ group.

The term "organic group" means a group containing one or more carbon atoms or a group formed by removing one hydrogen atom from an organic compound. Examples of the organic group include an alkyl group that may have one or more substituents, an alkenyl group that may have one or more substituents, an alkynyl group that may have one or more substituents, a cycloalkyl group that may have one or more substituents, a cycloalkenyl group that may have one or more substituents, a cycloalkadienyl group that may have one or more substituents, an aryl group that may have one or more substituents, an aralkyl group that may have one or more substituents, a non-aromatic heterocyclic group that may have one or more substituents, a heteroaryl group that may have one or more substituents, a cyano group, a formyl group, RaO-, RaCO-, $RaSO_2$-, RaCOO-, RaNRaCO-, RaCONRa-, RaOCO-, $RaOSO_2$-, and $RaNRbSO_2$- (where Ra independently represents an alkyl group that may have one or more substituents, an alkenyl group that may have one or more substituents, an alkynyl group that may have one or more substituents, a cycloalkyl group that may have one or more substituents, a cycloalkenyl group that may have one or more substituents, a cycloalkadienyl group that may have one or more substituents, an aryl group that may have one or more substituents, an aralkyl group that may have one or more substituents, a non-aromatic heterocyclic group that may have one or more substituents, or a heteroaryl group that may have one or more substituents, and Rb independently represents an alkyl group that may have H, or one or more substituents).

Among the organic groups, an alkyl group that may have 1 or more substituents is preferable.

In the general formula (10), $Rf^{11}$ represents a perfluoro organic group, and example thereof include a perfluoroalkyl group, a perfluoro(alkoxyalkyl) group, and the like.

As the perfluoroalkyl group, a perfluoroalkyl group having 1 to 10 carbon atoms and a perfluoroalkyl group having 1 to 5 carbon atoms are more preferable.

Examples of the perfluoroalkyl group having 1 to 10 carbon atoms include a perfluoromethyl group, a perfluoroethyl group, a perfluoropropyl group, a perfluorobutyl group, a perfluoropentyl group, a perfluorohexyl group, and the like.

Examples of the perfluoro(alkoxyalkyl) group include a perfluoro(alkoxyalkyl) group having 4 to 9 carbon atoms, a group represented by a general formula (10a) below, a group represented by a general formula (10b) below, and the like.

General formula (10a):

[Chem. 1]

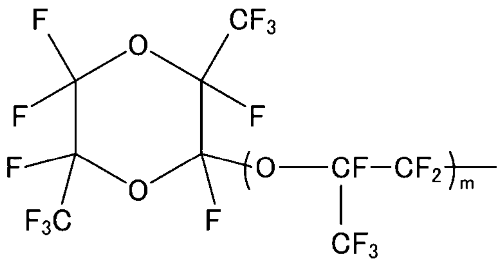

(In the formula, m represents an integer of 0 or 1 to 4.)

General formula (10b):

[Chem. 2]

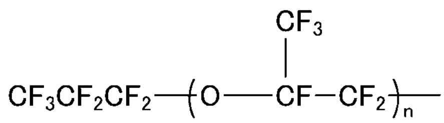

(In the formula, n represents an integer of 1 to 4.)

Among fluoromonomers represented by the general formula (10), perfluoro(alkyl vinyl ethers) [PAVE] wherein $Rf^{11}$ is a perfluoroalkyl group having 1 to 10 carbon atoms are preferable, and perfluoro(alkyl vinyl ethers) wherein $Rf^{11}$ is a perfluoroalkyl group having 1 to 5 carbon atoms are more preferable.

Among these, at least one type selected from the group consisting of perfluoro(methyl vinyl ether) [PMVE], perfluoro(ethyl vinyl ether) [PEVE], and perfluoro(propyl vinyl ether) [PPVE] is preferable, and at least one type selected from the group consisting of perfluoro(methyl vinyl ether) and perfluoro(propyl vinyl ether) is more preferable.

As the fluoromonomer represented by the general formula (30), at least one type selected from the group consisting of $CF_2{=}CFOCF_2OCF_3$, $CF_2{=}CFOCF_2OCF_2CF_3$, and $CF_2{=}CFOCF_2OCF_2CF_2OCF_3$ is preferable.

As the fluoromonomer represented by the general formula (40), at least one type selected from the group consisting of $CF_2{=}CFOCF_2CF(CF_3)O(CF_2)_3F$, $CF_2{=}CFO(CF_2CF(CF_3)O)_2(CF_2)_3F$, and $CF_2{=}CFO(CF_2CF(CF_3)O)_2(CF_2)_2F$ is preferable.

As the fluoromonomer represented by the general formula (50), at least one type selected from the group consisting of $CF_2{=}CFOCF_2CF_2SO_2F$, $CF_2{=}CFOCF_2CF\ (CF_3)OCF_2CF_2SO_2F$, $CF_2{=}CFOCF_2CF(CF_2CF_2SO_2F)OCF_2CF_2SO_2F$, and $CF_2{=}CFOCF_2CF(SO_2F)_2$ is preferable.

Among the perfluoro(alkyl vinyl ethers), at least one type selected from the group consisting of perfluoro(alkyl vinyl ethers) that are represented by the general formula (10) and in which $Rf^{11}$ is a perfluoroalkyl group having 1 to 5 carbon atoms, fluoromonomers represented by the general formula (30), and fluoromonomers represented by the general formula (40) is preferable.

-Other Copolymerizable Monomer-

Examples of the other copolymerizable monomer include other fluorine-containing ethylenic monomers, and monomers other than fluorine-containing monomers. One copolymerizable monomer may be used alone, or two or more copolymerizable monomers may be used in combination.

Examples of the other fluorine-containing ethylenic monomers include vinyl fluoride [VF], vinylidene fluoride [VdF], chlorotrifluoroethylene [CTFE], fluoromonomers represented by a general formula (60) below, fluoroalkylethylene represented by a general formula (70) below, and fluoroalkyl allyl ether represented by a general formula (80) below.

General formula (60): $CH_2{=}CFRf^{61}$

(In the formula, $Rf^{61}$ represents a linear or branched fluoroalkyl group having 1 to 12 carbon atoms.)

General formula (70): $CH_2=CH-(CF_2)_n-X^{71}$

(In the formula, $X^{71}$ is H or F, and n is an integer of 3 to 10.)

General formula (80): $CF_2=CF-CF_2-ORf^{81}$

(In the formula, $Rf^{81}$ represents a perfluoro organic group.)

In the general formula (60), $Rf^{61}$ is a linear or branched fluoroalkyl group having 1 to 12 carbon atoms, is preferably a linear fluoroalkyl group having 1 to 12 carbon atoms, and is more preferably a linear perfluoroalkyl group having 1 to 12 carbon atoms. The number of carbon atoms in $Rf^{61}$ is preferably 1 to 6.

Examples of the fluoromonomers represented by the general formula (60) include $CH_2=CFCF_3$, $CH_2=CFCF_2CF_3$, $CH_2=CFCF_2CF_2CF_3$, $CH_2=CFCF_2CF_2H$, $CH_2=CFCF_2CF_2CF_2CF_3$, $CHF=CHCF_3$ (E-form), $CHF=CHCF_3$ (Z-form), and the like.

Among these, 2,3,3,3-tetrafluoropropylene represented by $CH_2=CFCF_3$ is preferable.

As the fluoroalkylethylene represented by formula (70), at least one type selected from the group consisting of $CH_2=CH-C_4F_9$ and $CH_2=CH-C_6F_{13}$ is more preferable.

For $Rf^{81}$ in the above general formula (80), the particulars described about $Rf^{11}$ in the above general formula (10) may be appropriately selected. Yet, $Rf^{81}$ is preferably a perfluoroalkyl group having 1 to 10 carbon atoms or a perfluoroalkoxyalkyl group having 1 to 10 carbon atoms.

As the fluoroalkyl allyl ether represented by the general formula (80), at least one type selected from the group consisting of $CF_2=CF-CF_2-O-CF_3$, $CF_2=CF-CF_2-O-C_2F_5$, $CF_2=CF-CF_2-O-C_3F_7$, and $CF_2=CF-CF_2-O-C_4F_9$ is preferable, at least one type selected from the group consisting of $CF_2=CF-CF_2-O-C_2F_5$, $CF_2=CF-CF_2-O-C_3F_7$, and $CF_2=CF-CF_2-O-C_4F_9$ is more preferable, and $CF_2=CF-CF_2-O-CF_2CF_2CF_3$ is yet more preferable.

The monomers other than fluorine-containing monomers are not particularly limited and can be suitably selected according to the purpose, as long as they are monomer units that can be copolymerized with TFE, HFP and PAVE. Examples of the monomers other than fluorine-containing monomers include: non-fluorinated ethylenic monomers, such as ethylene, propylene, alkyl vinyl ether, and the like; and itaconic anhydride, citraconic anhydride, 5-norbornene-2,3-dicarboxylic anhydride, maleic anhydride, and the like.

The content of the perfluoro(alkyl vinyl ether) (PAVE) unit in the tetrafluoroethylene/perfluoro(alkyl vinyl ether) copolymer (also referred to as perfluoroalkoxyalkane (PFA)) is preferably 0.1 mass% or greater, more preferably 0.3 mass% or greater, yet more preferably 0.7 mass% or greater, still more preferably 1.0 mass% or greater, and particularly preferably 1.1 mass% or greater, and preferably 12 mass% or less, more preferably 8.0 mass% or less, yet more preferably 6.5 mass% or less, and particularly preferably 6.0 mass% or less relative to all polymerized units.

The content of PAVE units can be measured by the $^{19}F$-NMR method.

The mass ratio (TFE/HFP) of tetrafluoroethylene (TFE) units to hexafluoropropylene (HFP) units in the tetrafluoroethylene/hexafluoropropylene copolymer (also referred to as fluorinated ethylene propylene (FEP)) is preferably 70/30 to 99/1, and more preferably 85/15 to 95/5.

The content of HFP units in the FEP is preferably 1 mass% or greater, and more preferably 1.1 mass% or greater relative to all monomer units.

It is preferable that the FEP contains PAVE units in addition to the TFE units and the HFP units. Examples of the PAVE units contained in the FEP may include the same as the PAVE units constituting the PFA. Among them, PPVE is particularly preferable.

In the case where the FEP contains TFE units, HFP units and PAVE units, the mass ratio (TFE : HFP : PAVE) is preferably 70 to 99.8 : 0.1 to 25 : 0.1 to 25 and more preferably 75 to 98 : 1.0 to 15 : 1.0 to 10 from the viewpoint of excellent heat resistance and chemical resistance.

The content of the HFP units and the PAVE units in the FEP is preferably 1 mass% or greater, and more preferably 1.1 mass% or greater relative to all monomer units.

The content of the HFP units in the FEP is preferably 25 mass% or less, more preferably 20 mass% or less, yet more preferably 18 mass% or less, and particularly preferably 15 mass% or less, and preferably 0.1 mass% or greater, more preferably 1 mass% or greater, and yet more preferably 2 mass% or greater relative to all monomer units from the viewpoint that a solid composition having excellent heat resistance can be obtained.

In the case where the FEP contains TFE units, HFP units, PAVE units, and the other copolymerizable monomer, the mass ratio (TFE : HFP : PAVE : other copolymer monomer) is preferably 70 to 98 : 0.1 to 25 : 0.1 to 25 : 0.1 to 10.

The content of the monomer units other than the TFE units in the FEP is preferably 1 mass% or greater and more preferably 1.1 mass% or greater relative to all monomer units.

It is also preferable that the fluororesin is a mixture of the PFA and the FEP. In other words, the PFA and the FEP can be used while being mixed. The mass ratio of the PFA to the FEP (PFA/FEP) is preferably 90/10 to 30/70, and more preferably 90/10 to 50/50.

The fluororesin can be produced by a conventionally publicly-known method, such as emulsion polymerization or suspension polymerization of a mixture of the monomers as the constituent units thereof, and as needed, additives, such as a polymerization initiator and the like.

[Unstable End Groups Present at End of Main Chain of Fluororesin]

The number of unstable end groups present at an end of the main chain of the fluororesin is preferably small from the viewpoint of electrical properties. Specifically, the number of unstable end groups is preferably less than 700, more preferably less than 100, and yet more preferably less than 50 per $1\times10^6$ carbon atoms of the fluororesin. The lower limit is not particularly limited.

The unstable end groups are preferably at least one type selected from the group consisting of $-CF_2H$, -COF, -COOH, $-COOCH_3$, $-CONH_2$, and $-CH_2OH$, and may be associated with water.

The number of the $-CF_2H$ end groups present at an end of the main chain of the tetrafluoroethylene/perfluoro(alkyl vinyl ether) copolymer (PFA) is preferably less than 600, more preferably less than 200, yet more preferably less than 100, and particularly preferably less than 30 per $1\times10^6$ carbon atoms of the PFA for the improvement of electrical properties (in particular, loss tangent). The lower limit is not particularly limited.

It is possible to reduce the number of the unstable end groups by, for example, fluorinating the fluororesin.

The fluorination treatment can be carried out by a publicly-known method, such as, for example, by bringing the fluororesin that has not been fluorinated into contact with a fluorine-containing compound.

As the fluorine-containing compound, a fluorine radical source that produces fluorine radicals under fluorination treatment conditions can be used, and examples of the fluorine-containing compound include $F_2$ gas, $CoF_3$, $AgF_2$, $UF_6$, $OF_2$, $N_2F_2$, $CF_3OF$, and halogen fluoride (for example, $IF_3$, $ClF_3$, and the like).

[Method for Identifying Fluororesin]

Identification of the fluororesin and the number of the unstable end groups can be performed by identifying the constituent components by, for example, an analysis method by the Infrared Attenuated Total Reflection method (IR-ATR method) using a Fourier transform infrared spectrometer (FT-IR). Th FT-IR measurement can be performed using, for example, a Nicolet 6700 (available from Thermo Fisher Scientific Inc.).

Specifically, as the method for identifying the number of the unstable end groups, a film-shaped sample having an average thickness of 0.25 mm to 0.3 mm is prepared using the fluororesin. The sample is analyzed by the Fourier transform infrared spectroscopy to obtain an infrared absorption spectrum of the fluororesin, and a difference spectrum of the spectrum from the base spectrum of a standard sample formed using a fluororesin that has been completely fluorinated and has no unstable end groups is obtained. From the absorption peak of a specific unstable end group appearing in the difference spectrum, the number N of unstable end groups per $10^6$ carbon atoms of the fluororesin can be calculated according to the following equation (A).

Note that the sample can be prepared by being cut out from a pellet or a sheet obtained by molding the fluororesin.

$$N=I\times K/t \qquad (A)$$

I: Absorbance
K: Correction factor
t: Average thickness (mm) of the film (sample)

The melting point of the fluororesin is not particularly limited and can be appropriately selected according to the purpose. However, from the viewpoint of facilitating melt-kneading, the melting point is preferably 240°C to 340°C.

The upper limit of the melting point is more preferably 318°C or lower, and more preferably 315°C or lower. The lower limit is more preferably 245°C or higher, and more preferably 250°C or higher.

The melting point of the fluororesin can be measured as the temperature corresponding to a local maximum value of a heat-of-melting curve obtained when raising the temperature of the fluororesin at a rate of 10°C/min using a differential scanning calorimeter (DSC).

The melt flow rate (MFR) of the fluororesin at 372°C is not particularly limited and can be suitably selected according to the purpose. However, from the viewpoint of facilitating melt-kneading, the melt flow rate is preferably 0.1 g/10 minutes to 100 g/10 minutes, more preferably 0.5 g/10 minutes or greater, and yet more preferably 1.5 g/10 minutes or

greater, and is preferably 80 g/10 minutes or less, and more preferably 40 g/10 minutes or less.

The MFR is a value obtained as the mass (g/10 min) of a polymer discharged per 10 minutes from a nozzle having an inner diameter of 2 mm and a length of 8 mm under a load of 5 kg at 372°C, using, for example, a melt indexer (available from Yasuda Seiki Seisakusho, Ltd.) in accordance with American Society for Testing and Materials (ASTM) D1238.

The relative permittivity of the fluororesin is not particularly limited and may be appropriately selected according to the purpose. However, a relative permittivity at 25°C at a frequency of 10 GHz is preferably 4.5 or less, more preferably 4.0 or less, yet more preferably 3.5 or less, and particularly preferably 2.5 or less. The lower limit value is not particularly limited, but may be, for example, 1.0 or greater.

The loss tangent of the fluororesin is not particularly limited and may be appropriately selected according to the purpose. However, a loss tangent at 25°C at 10 GHz is preferably 0.01 or less, more preferably 0.008 or less, and even more preferably 0.005 or less. The lower limit value is not particularly limited, but may be, for example, 0.0001 or greater.

The content of the fluororesin is not particularly limited and may be appropriately selected according to the purpose. However, relative to the total amount of the solid composition, the content of the fluororesin is preferably 40 mass% to 95 mass%, more preferably 45 mass% or greater and even more preferably 50 mass% or greater, as well as more preferably 90 mass% or less, and even more preferably 80 mass% or less.

<Fibrous Anisotropic Filler>

The fibrous anisotropic filler is particles having an anisotropic shape (varied in diameter depending on the directions), and has a fibrous shape.

The aspect ratio of the anisotropic filler, expressed as a ratio of the longest diameter to the shortest diameter of the anisotropic filler, or a ratio of the fiber length to the fiber diameter of the anisotropic filler, is preferably 100 or greater, more preferably 200 or greater, and more preferably 500 or greater.

The upper limit of the aspect ratio is preferably 2,000 or less, and more preferably 1,000.

The fibrous anisotropic filler is not particularly limited and can be selected appropriately according to the purpose. Examples of the fibrous anisotropic filler include: inorganic compounds, such as zinc oxide, silica, titanium oxide, zirconium oxide, tin oxide, silicon nitride, silicon carbide, boron nitride, calcium carbonate, calcium silicate, potassium titanate, aluminum nitride, indium oxide, alumina, antimony oxide, cerium oxide, magnesium oxide, iron oxide, tin-doped indium oxide (ITO), and the like; minerals, such as montmorillonite, talc, mica, boehmite, kaolin, smectite, zonolite, verculite, sericite, and the like; carbon compounds, such as carbon nanotubes and the like; various types of glass, such as glass fibers and the like; and the like.

One type of fibrous anisotropic filler may be used alone or two or more types may be used in combination.

In addition, the fibrous anisotropic filler may include a fibrous anisotropic filler that is surface-functionalized.

Among these, silica is preferable.

The content of the fibrous anisotropic filler is not particularly limited and can be appropriately selected according to the purpose, yet is preferably 5 mass% to 60 mass%, more preferably 10 mass% or greater, more preferably 20 mass% or greater, as well as more preferably 55 mass% or less, and yet more preferably 50 mass% or less relative to the total amount of the solid composition.

The mass ratio (A/B) of the fibrous anisotropic filler (A) to the fluororesin (B) is not particularly limited and can be appropriately selected according to the purpose, yet is preferably 5/95 to 60/40, more preferably 10/90 to 55/45, and even more preferably 20/80 to 50/50.

[Method for Identifying Fibrous Anisotropic Filler]

As the method for identifying the fibrous anisotropic filler, for example, there is a method for identifying the fibrous anisotropic filler by observing the shape of a cross-section of the solid composition by microscopy (for example, measuring the aspect ratio of the anisotropic filler) or by observing the shape of the solid composition by X-ray CT.

<Other Components>

The solid composition of the present disclosure may contain other components as needed. Examples of the other components include bulking agents, crosslinking agents, antistatic agents, heat-resistant stabilizers, foaming agents, foaming nucleators, antioxidants, surfactants, photopolymerization initiators, abrasion inhibitors, surface modifiers, resins other than the fluororesin, fillers other than the fibrous anisotropic filler, liquid crystal polymers, and the like.

The fillers are not particularly limited and can be selected appropriately according to the purpose. Examples of the filler include: inorganic compounds, such as zinc oxide, silica, titanium oxide, zirconium oxide, tin oxide, silicon nitride, silicon carbide, boron nitride, calcium carbonate, calcium silicate, potassium titanate, aluminum nitride, indium oxide, alumina, antimony oxide, cerium oxide, magnesium oxide, iron oxide, tin doped indium oxide (ITO), and the like; Minerals,

such as montmorillonite, talc, mica, boehmite, kaolin, smectite, zonolite, verculite, sericite, and the like; carbon compounds, such as carbon black, acetylene black, Ketjen black, carbon nanotubes, and the like; metal hydroxides, such as aluminum hydroxide, magnesium hydroxide, and the like; various types of glass, such as glass beads, glass flakes, glass balloons, and the like; and the like.

One filler may be used alone or two or more fillers may be used in combination.

As the filler, one that has ultraviolet absorbency is preferable. Examples include zinc oxide, titanium oxide, and the like. Zinc oxide is preferred. Having ultraviolet absorbency means that the absorbance of light having a wavelength of 355 nm is 0.1 or greater. The absorbance of light having a wavelength of 355 nm is a value measured from a powder of the filler filled to a thickness of 100 μm, using an ultraviolet-visible-near-infrared spectrophotometer (for example, "V-770" available from JASCO Corporation) at a reflecting position.

The shape of the filler is not particularly limited, and a shape other than a fibrous shape can be suitably selected according to the purpose. Examples of the shape include a scale-like shape, a plate-like shape, a needle-like shape, a grainy shape, a spherical shape, a columnar shape, a spindle shape, a frustum shape, a polyhedral shape, a hollow shape, and the like.

The average particle diameter of the filler is preferably 0.01 μm to 20 μm, more preferably 0.02 μm or greater, and yet more preferably 0.03 μm or greater, and is more preferably 5 μm or less, and yet more preferably 2 μm or less.

The average particle diameter can be measured by a laser diffraction/scattering method.

The filler may be surface-functionalized, for example, with a silicone compound.

By surface-functionalizing the filler with the silicone compound, it is possible to reduce the relative permittivity of the filler.

The silicone compound is not particularly limited and may be selected appropriately according to the purpose, yet it is preferable that at least one type selected from the group consisting of silane coupling agents and organosilazane is contained.

The amount of surface-functionalization with the silicone compound, expressed as the reaction amount of the surface treatment agent per unit surface area ($nm^2$) of the filler, is preferably 0.1 to 10 molecules, and more preferably 0.3 to 7 molecules.

The functional group of the silane coupling agent is preferably at least one selected from the group consisting of a fluorine-containing group, an amino group, a vinyl group, and an epoxy group, more preferably at least one selected from the group consisting of a fluorine-containing group, an amino group, and a vinyl group, and yet more preferably a fluorine-containing group and an amino group.

[Properties of Solid Composition]

-Linear Expansion Coefficient-

The linear expansion coefficient of the solid composition at 20°C to 200°C is preferably 50 ppm/°C or less and more preferably 40 ppm/°C or less as an average linear expansion coefficient in a temperature range of 20°C to 200°C. The lower limit is not particularly limited, but may be, for example, 10 ppm/°C.

-Reduction Ratio of Linear Expansion Coefficient-

The reduction ratio of the linear expansion coefficient of the solid composition at 20°C to 200°C to the linear expansion coefficient of the fluororesin at 20°C to 200°C is 50% or greater, preferably 55% or greater, yet more preferably 60%, and most preferably 65%.

When the reduction ratio of the linear expansion coefficient is 50% or greater, the linear expansion coefficient of the solid composition to be obtained can be sufficiently reduced from the linear expansion rate of the fluororesin used, and a solid composition excellent in moldability can be obtained.

The linear expansion coefficient of the solid composition at 20°C to 200°C can be measured under the following measurement conditions using a thermomechanical analyzer (for example, EXSTAR6000TMA/SS6000, available from SII Nanotechnology Inc.), from a sheet having an average thickness of 25 μm, formed from the solid composition.

--Measurement Conditions--

Step 1: Temperature is raised to 150°C at a temperature raising rate of 5 °C/min to remove adsorbed water from the sample.

Step 2: Air cooling to room temperature is performed at a temperature lowering rate of 5 °C/min.

Step 3: The main measurement is performed at a temperature raising rate of 5 °C/min.

The average linear expansion coefficient in the temperature range of 20°C to 200°C in the main measurement is

calculated as the intended linear expansion coefficient of the solid composition.

The linear expansion coefficient of the fluororesin at 20°C to 200°C can be similarly measured by using the fluororesin instead of the solid composition.

-Relative Permittivity-

The relative permittivity of the solid composition at 25°C at 10 GHz is preferably 2.5 or less, and more preferably 2.4 or less. The lower limit is not particularly set, but may be, for example, 1.0. When the relative permittivity is in the above range, the solid composition can be suitably used for a circuit board.

The relative permittivity of the solid composition at 25°C at 10 GHz can be measured by the SPDR method (resonator method) using a vector network analyzer (e.g., E5063A, available from Keysight Technologies), from a sheet having an average thickness of 2.5 μm, formed from the solid composition.

-Loss Tangent-

The loss tangent of the solid composition at 25°C at 10 GHz is preferably 0.003 or less, more preferably 0.002 or less, and yet more preferably 0.0015 or less. The lower limit is not particularly limited, but may be, for example, 0.0001. When the loss tangent is in the above range, the solid composition can be suitably used for a circuit board.

The loss tangent of the solid composition at 25°C at 10 GHz can be measured by the SPDR method (resonator method) using a vector network analyzer (e.g., E5063A, available from Keysight Technologies), from a sheet having an average thickness of 2.5 μm, formed from the solid composition.

The shape of the solid composition is not particularly limited and can be selected appropriately according to the purpose, and examples of the shape include pellet, film, sheet, and the like. For use for a circuit board, film or sheet are preferred. For use as a molding material, pellet is preferred.

The number of voids in the solid composition is preferably 30 or less, more preferably 25 or less, and yet more preferably 20 or less, and may be 0 as the number of voids having a width of 30 μm or greater per 1 $mm^2$ of an image observed in an image analysis by laser microscope observation. When the number of voids is in the above range, moldability (in particular, sheet formability and strand take-up stability) is better.

The image analysis by laser microscope observation is performed on a cross-section of the solid composition pelletized.

[Application]

Since the solid composition can have a reduced (improved) linear expansion coefficient, and can achieve both of a low dielectric constant of 2.5 or less and a low linear expansion coefficient of 50 ppm/°C or less, it can be suitably used as an insulating material (in particular, a low dielectric material) or a heat conductive material for a circuit board.

(Circuit Board)

The circuit board of the present disclosure includes an insulating layer containing the solid composition of the present disclosure and a conductive layer, and may include other layers as necessary.

<Insulating Layer>

The insulating layer is a layer containing the solid composition and is preferably a layer composed of the solid composition.

The average thickness of the insulating layer is not particularly limited, can be appropriately selected according to the purpose, and may be, for example, 1 μm to 1 mm, is preferably 20 μm or greater, more preferably 30 μm or greater, and yet more preferably 50 μm or greater, as well as preferably 800 μm or less, and more preferably 600 μm or less.

The average thickness can be calculated as an average value of thicknesses measured at ten or more arbitrary points.

When forming a film from the dispersion liquid described in PTL 2, it is usually difficult to form the film to have a thickness of 50 μm or greater. However, when forming a film from the solid composition, it is possible to form the film to have a thickness 50 μm or greater easily.

<Conductive Layer>

The conductive layer is a layer containing a metal, and is preferably a layer made of a metal. The conductive layer

may be provided on only one side or both sides of the insulating layer.

Examples of the metal include copper, stainless steel, aluminum, iron, silver, gold, ruthenium, and the like; alloys thereof; and the like. Among these, copper is preferable. Examples of the copper include rolled copper and electrolytic copper.

The surface roughness Rz of a surface of the conductive layer on the solid composition side is preferably 2.0 μm or less, more preferably 1.8 μm or less, and yet more preferably 1.5 μm or less. As a result, transmission loss at a junction formed when the insulating layer and the conductive layer are joined can be mitigated.

The surface roughness Rz is preferably 0.3 μm or greater, and more preferably 0.5 μm or greater. The surface roughness Rz is a value (maximum height roughness) calculated by the method according to Japan Industrial Standards (JIS) C 6515-1998.

The average thickness of the conductive layer is not particularly limited, can be selected appropriately according to the purpose, and is preferably 2 μm to 200 μm and more preferably 5 μm to 50 μm.

<Another Layer>

In addition to the insulating layer and the conductive layer, the circuit board of the present disclosure may include another layer formed of a resin other than the fluororesin.

Examples of the resin other than the fluororesin include thermosetting resins and resins other than thermosetting resins. Among these, thermosetting resins are preferable.

As the thermosetting resin, at least one type selected from the group consisting of polyimide, modified polyimide, epoxy resin, and thermosetting modified polyphenylene ether is preferable, epoxy resin, modified polyimide, and thermosetting modified polyphenylene ether are more preferable, and epoxy resin and thermosetting modified polyphenylene ether are yet more preferable.

As the resin other than thermosetting resins, at least one selected from the group consisting of liquid crystal polymer, polyphenylene ether, thermoplastic modified polyphenylene ether, cycloolefin polymer, cycloolefin copolymer, polystyrene, and syndiotactic polystyrene is preferable.

The average thickness of the another layer is preferably 5 μm or greater and more preferably 10 μm or greater, and is preferably 2,000 μm or less and more preferably 1,500 μm or less.

It is preferable that the circuit board is a sheet. The average thickness of the circuit board is preferably 20 μm or greater and more preferably 30 μm or greater, as well as preferably 5,000 μm or less and more preferably 3,000 μm or less.

The circuit board can be suitably used as a printed circuit board, a laminated circuit board (multilayer board), and a high-frequency board.

The high-frequency circuit board is a circuit board that can be operated even in a high-frequency band.

The high-frequency band may be a band of 1 GHz or higher, preferably 3 GHz or higher, and more preferably 5 GHz or higher. The upper limit is not particularly limited, yet the high-frequency band may be 100 GHz or lower.

(Method of Manufacturing Solid Composition)

A method of manufacturing the solid composition of the present disclosure is not particularly limited, and can be selected appropriately according to the purpose. Examples of the method include melt-kneading, injection molding, blow molding, inflation molding, and vacuum/pressure forming; extrusion or casting of a paste in a state of being dispersed or dissolved in a solvent; and the like.

Among these, a melt-kneading method is suitably used.

The method of manufacturing the solid composition according to the present disclosure is a method of melt-kneading the fluororesin and the anisotropic filler to obtain the solid composition.

The machine used for the melt-kneading is not particularly limited and can be selected appropriately according to the purpose. Examples of the machine include a twin-screw extruder, a single-screw extruder, a multi-screw extruder, a tandem extruder, and the like.

The melt-kneading time is preferably from 10 seconds to 1,800 seconds and more preferably from 60 seconds to 1,200 seconds, and may be, for example, 300 seconds (5 minutes). When the time is excessively long, the fluororesin may deteriorate. When the time is extremely short, the fibrous anisotropic filler may not be sufficiently dispersed.

The rotational speed of the melt-kneading is preferably from 5 rpm to 200 rpm and more preferably from 10 rpm to 100 rpm, and may be, for example, 50 rpm.

The temperature of the melt-kneading may be any temperature that is higher than the melting point of the fluororesin, and is preferably from 240°C to 450°C, and more preferably from 260°C to 400°C.

(Proposal Apparatus)

A proposal apparatus of the present disclosure is a proposal apparatus including a controller configured to propose a kneading condition for manufacturing a solid composition containing a fluororesin and a filler.

The controller is configured to:

input the kneading condition for search into a trained model trained by using training data including the kneading condition for training and an index value related to a linear expansion coefficient and a dielectric property of the solid composition manufactured under the kneading condition for training, to thereby output a predicted index value; and optimize the kneading condition for search based on the predicted index value and a target index value, and output the kneading condition optimized.

The proposal apparatus of the present disclosure can propose a kneading condition under which the linear expansion coefficient and the dielectric property satisfy a predetermined condition, for when manufacturing a solid composition containing a fluororesin and a filler.

<System Configuration of System Including Proposal Apparatus (Training phase)>

Next, the overall system configuration of a processing system including a proposal apparatus according to a first embodiment will be described.

FIG. 1 is a diagram showing an example of the system configuration of a processing system including a proposal apparatus in a training phase. As shown in FIG. 1, a processing system 100 includes a kneader 130, evaluation apparatuses 151 and 152, and a proposal apparatus 180.

In the training phase, the kneader 130 kneads a fluororesin and a filler under various kneading conditions to manufacture solid compositions. In FIG. 1, kneading conditions 1 to n (see the reference numeral 110) indicate that n patterns of kneading conditions were used to manufacture solid compositions (see the reference numeral 140) in the training phase.

In the processing system 100, each kneading condition includes a filler shape (fibrous shape, spherical shape, or plate-like shape) and a blending ratio (see the reference numeral 110_2).

The kneader 130 kneads:

- a filler (see the reference numeral 120) having a shape (see the reference numeral 110_1) defined in each kneading condition, and prepared in an amount corresponding to a blending ratio (see the reference numeral 110_1) defined in each kneading condition; and
- a specific fluororesin (see the reference numeral 120) prepared in an amount corresponding to the blending ratio (see reference numeral 110_1) defined in each kneading condition.

The kneader 130 operates based on:

- a kneading rotational speed (see the reference numeral 110_2) defined in each kneading condition; and
- a kneading time (see the reference numeral 110_2) defined in each kneading condition.

In the processing system 100, the properties of the solid composition (see the reference numeral 140) manufactured under each kneading condition are evaluated by the evaluation apparatus 151 and the evaluation apparatus 152. The evaluation apparatus 151 evaluates the linear expansion coefficient of the solid composition, and the evaluation apparatus 152 evaluates the dielectric properties (loss tangent, relative permittivity, dielectric loss, and the like) of the solid composition.

In the processing system 100, the linear expansion coefficient and the dielectric properties (see the reference numeral 161) of the solid composition manufactured under each kneading condition are converted into a predetermined index value (a value calculated based on a predetermined Figure of Merit (FOM) formula, described below) (see the reference numeral 162). Training data 170 is generated by associating the index value of the solid composition manufactured under each kneading condition with each kneading condition.

In the processing system 100, the generated training data is processed in the proposal apparatus 180. In the training phase, the proposal apparatus 180 performs training processing on a training-target model by using the training data to generate a trained model.

In the example of FIG. 1, the actor of the processing for conversion to the predetermined index value and the processing for generating the training data 170 has not been mentioned. The conversion processing and the generation processing may be performed by, for example, the proposal apparatus 180. Alternatively, the conversion processing and

the generation processing may be performed by an apparatus other than the proposal apparatus 180.

<Hardware Configuration of Proposal Apparatus>

Next, the hardware configuration of the proposal apparatus 180 will be described. FIG. 2 is a diagram showing an example of the hardware configuration of the proposal apparatus. As shown in FIG. 2, the proposal apparatus 180 includes a processor 201, a memory 202, an auxiliary storage device 203, a connection device 204, a communication device 205, and a drive device 206. The hardware components included in the proposal apparatus 180 are connected to each other via a bus 207.
The processor 201 includes various computing devices, such as a Central Processing Unit (CPU), a Graphics Processing Unit (GPU), and the like. The processor 201 reads out various programs (for example, a proposal program and the like) into the memory 202 and executes the programs
The memory 202 includes a main storage device, such as a Read Only Memory (ROM), a Random Access Memory (RAM), and the like. The processor 201 and the memory 202 form what is generally referred to as a computer (also referred to as a "controller"), and the computer realizes various functions by the processor 201 executing various programs read out into the memory 202.
The auxiliary storage device 203 stores various programs and various information used when the various programs are executed by the processor 201.
The connection device 204 is a connection device that connects to external devices (an operating device 211, a display device 212, and the like).
The communication device 205 is a communication device that is connected to a network (not shown) for exchanging information with each device on the network.
The drive device 206 is a device in which a recording medium 213 is set. Examples of the recording medium 213 as used herein include a medium for recording information optically, electrically, or magnetically, such as a CD-ROM, a flexible disk, a magneto-optical disk, and the like. Examples of the recording medium 213 may also include a semiconductor memory for recording information electrically, such as a ROM, a flash memory, and the like.
Various programs to be installed in the auxiliary storage device 203 are installed by, for example, a distributed recording medium 213 being set in the drive device 206 and various programs recorded in the recording medium 213 being read out by the drive device 206. Alternatively, various programs to be installed in the auxiliary storage device 203 may be installed by being downloaded from a network (not shown) via the communication device 205.

<Specific Example of Training Data>

Next, a specific example of the training data 170 will be described. FIG. 3 is a diagram showing an example of the training data.
As shown in FIG. 3, the training data 170 includes "kneading condition" and "index value" as information items. The "kneading condition" further includes "filler shape", "blending ratio", "kneading rotational speed", and "kneading time" as detailed information items. The "index value" further includes "FOM calculation result" as a detailed information item.
"Filler shape" include "fibrous" and "spherical". "Fibrous" refers to a filler having a fibrous shape, and "spherical" refers to a filler having a spherical shape. As shown in FIG. 3, in the field corresponding to the item "fibrous" or "spherical",

- 0 is input when a filler having a fibrous shaper or a filler having a spherical shape is not surface-functionalized and has a small particle diameter,
- 1 is input when a filler having a fibrous shape or a filler having a spherical shape is surface-functionalized and has a small particle diameter,
- 2 is input when a filler having a fibrous shape or a filler having a spherical shape is not surface-functionalized and has a large particle diameter, and
- 3 is input when a filler having a fibrous shape or a filler having a spherical shape is surface-functionalized and has a large particle diameter.

Furthermore, "filler shape" includes "plate-like". "Plate-like" refers to a filler having a plate-like shape. As shown in FIG. 3, in the field corresponding to the item "Plate-like",

- 0 is input when a filler having a plate-like shape is not surface-modified, and
- 1 is input when a filler having a plate-like shape is surface-modified.

The "blending ratio" includes "fibrous", "spherical", and "plate-like". As described above, "fibrous" refers to a filler having a fibrous shape, "spherical" refers to a filler having a spherical shape, and "plate-like" refers to a filer having a plate-like shape. As shown in FIG. 3, in the field corresponding to the item "fibrous", the mass of a filler having a fibrous shape relative to a predetermined mass of a specific fluororesin is input. In the field corresponding to the item "spherical", the mass of a filler having a spherical shape relative to a predetermined mass of a specific fluororesin is input. In the field corresponding to the item "plate-like", the mass of a filler having a plate-like shape relative to a predetermined mass of a specific fluororesin is input.

In the field corresponding to the item "kneading rotational speed", the rotational speed (rpm) of the rotor during kneading by the kneader 130 is input. In the field corresponding to the item "kneading time", a kneading time (min) for kneading by the kneader 130 is input. In the field corresponding to the item "FOM calculation result", an index value related to linear expansion coefficient and dielectric properties is input.

<Explanation of Index Value>

Next, a predetermined FOM formula used to calculate the index value related to the linear expansion coefficient and dielectric properties will be described. FIG. 4 shows details of the index value calculation method. Assuming that x represents the linear expansion coefficient of the solid composition and y represents the dielectric properties of the solid composition (here, y represents the product of the loss tangent and a square root of the relative permittivity), as shown in FIG. 4, the FOM formula used to calculate the index value can be expressed as follows:

$$\text{(Formula)}\quad FOM = (x_{max}-x)/x_{_range}-(y-y_{min})/y_{_range}$$

In the above equation, $x_{max}$ represents the linear expansion coefficient of the fluororesin, and $y_{min}$ represents the dielectric properties of the fluororesin. Further, $x_{_range}$ represents, for example, the variation range of the linear expansion coefficients of solid compositions analyzed in the past, and $y_{_range}$ represents, for example, the variation range of the dielectric properties of solid compositions analyzed in the past.

According to the above FOM formula, the lower the linear expansion coefficient of the solid composition and the lower the dielectric properties, the larger the index value.

<Functional Configuration of Proposal Apparatus (Training Phase)>

Next, the functional configuration of the proposal apparatus 180 in the training phase will be described. FIG. 5 is a diagram showing an example of the functional configuration of the proposal apparatus in the training phase. As described above, a proposal program is installed in the proposal apparatus 180, and the proposal apparatus 180 functions as a training unit 500 when the proposal program is executed in the training phase.

As shown in FIG. 5, the training unit 500 includes a training-target model 510 and a comparison/change unit 520. The data in each field corresponding to each item of the "Kneading condition" in the training data 170 is input to the training-target model 510 as input data. When the input data is input into the training-target model 510, the training-target model 510 outputs output data. The data in the field corresponding to the item "index value" in the training data 170 is input into the comparison/change unit 520 as ground truth data. The comparison/change unit 520 calculates an error based on the output data output from the training-target model 510 and the ground truth data, and updates the model parameters of the training-target model 510 according to the calculated error. In this way, the training unit 500 generates a trained model by performing training processing on the training-target model 510 using the training data 170.

<Flow of Processing in Training Phase>

Next, the flow of processing in the training phase of the processing system 100 will be described. FIG. 6 is an example of a flowchart showing the flow of processing in the training phase of the processing system.

In step S601, the kneader 130 kneads a fluororesin and a filler under each kneading condition, to form a solid composition.

In step S602, the evaluation apparatuses 151 and 152 evaluate the linear expansion coefficient and the dielectric properties of the manufactured solid composition, respectively. In addition, the proposal apparatus 180 calculates the index value using the predetermined FOM formula.

In step S603, the proposal apparatus 180 generates training data by associating the kneading condition with the index value.

In step S604, the proposal apparatus 180 performs training processing on the training-target model 510 using the training data, to generate a trained model.

In step S605, the proposal apparatus 180 stores the generated trained model.

<System Configuration of System Including Proposal Apparatus (Proposal Phase)>

Next, the system configuration of a processing system including a proposal apparatus 180 in a proposal phase will be described. FIG. 7 is a diagram showing an example of the system configuration of a processing system including a proposal apparatus in a proposal phase. As shown in FIG. 7, a processing system 700 includes a proposal apparatus 180, a kneader 130, and evaluation apparatuses 151 and 152.

In the proposal phase, a target linear expansion coefficient and target dielectric properties are input into the proposal apparatus 180. The proposal apparatus 180 searches for a kneading condition that satisfies the target linear expansion coefficient and the target dielectric properties.

The kneader 130 kneads:

- a filler (see the reference numeral 720) having a shape (see the reference numeral 710_1) defined in the searched-out kneading condition (see the reference numeral 710) and prepared in an amount corresponding to a blending ratio (see the reference numeral 710_1) defined in the searched-out kneading condition, and
- a specific fluororesin (see the reference numeral 720) prepared in an amount corresponding to the blending ratio (see the reference numeral 710_1) defined in the searched-out kneading condition (see the reference numeral 710).

The kneader 130 operates based on:

- a kneading rotational speed (see the reference numeral 710_2) defined in the searched-out kneading condition (see the reference numeral 710), and
- a kneading time (see the reference numeral 710_2) defined in the searched-out kneading condition (see the reference numeral 710).

As shown in FIG. 7, the properties of the solid composition (see the reference numeral 740) manufactured under the searched-out kneading condition are evaluated by the evaluation apparatus 151 and the evaluation apparatus 152. Specifically, the evaluation apparatus 151 evaluates the linear expansion coefficient of the manufactured solid composition, and the evaluation apparatus 152 evaluates the dielectric properties of the manufactured solid composition (see the reference numeral 760).

Thus, it is possible to confirm that the linear expansion coefficient and the dielectric properties of the solid composition manufactured under the kneading condition searched out by the proposal apparatus 180 satisfy the target linear expansion coefficient and the target dielectric properties. If the linear expansion coefficient of the manufactured solid composition does not satisfy the target linear expansion coefficient, or if the dielectric properties of the manufactured solid composition do not satisfy the target dielectric properties, a solid composition is manufactured under another kneading condition searched out by the proposal apparatus 180.

<Functional Configuration of Proposal Apparatus (Proposal Phase)>

Next, the functional configuration of the proposal apparatus 180 in the proposal phase will be described. FIG. 8 shows an example of the functional configuration of the proposal apparatus in the proposal phase. As described above, a proposal program is installed in the proposal apparatus 180, and the proposal apparatus 180 functions as a prediction unit 810, a target index value calculation unit 820, an evaluation unit 830, and an optimization unit 840 when the proposal program is executed in the proposal phase.

As shown in FIG. 8, the prediction unit 810 includes a trained model 811. A kneading condition for search, output from the optimization unit 830, is input into the trained model 811. In response to the kneading condition for search being input, the trained model 811 predicts a predicted index value.

The target index value calculation unit 820 calculates a target index value by using the predetermined FOM formula shown in FIG. 5 based on the target linear expansion coefficient and the target dielectric properties that are input.

The evaluation unit 830 calculates an error between the predicted index value predicted by the trained model 811 and the target index value. The evaluation unit 830 notifies the optimization unit 840 about the calculated error.

The optimization unit 840 determines whether or not the error provided as notification by the evaluation unit 830 satisfies a predetermined condition (whether or not the error is equal to or less than a predetermined threshold). When determining that the error is not equal to or less than the predetermined threshold, the optimization unit 840 generates a kneading condition for search and inputs it to the trained model 811. The optimization unit 840 explores the kneading condition for search, under which the error becomes equal to or less than the predetermined threshold, by, for example, Bayesian Optimization.

When determining that the error provided as notification by the evaluation unit 830 is equal to or less than the predetermined threshold, the optimization unit 840 outputs the corresponding kneading condition search, as a searched-out kneading condition.

<Flow of Processing in Proposal Phase>

Next, the flow of processing in the proposal phase of the processing system 700 will be described. FIG. 9 is an example of a flowchart showing the flow of processing in the proposal phase of the processing system.

In step S901, the proposal apparatus 180 receives an input of a target linear expansion coefficient and target dielectric properties.

In step S902, the proposal apparatus 180 calculates a target index value based on the target linear expansion coefficient and the target dielectric properties.

In step S903, the proposal apparatus 180 predicts a predicted index value by inputting a kneading condition for search into the trained model.

In step S904, the proposal apparatus 180 determines whether or not an error between the predicted index value and the target index value satisfies a predetermined condition. When it is determined that the predetermined condition is not satisfied (NO in step S904), the process proceeds to step S905. Alternatively, when the proposal apparatus 180 determines that the predetermined condition is satisfied but that the searching has not been performed a predetermined number of times, the process proceeds to step S905.

In step S905, the proposal apparatus 180 changes the kneading condition for search based on Bayesian Optimization, and returns to step S903.

On the other hand, when it is determined in step S904 that the predetermined condition is satisfied (YES in step S904), the process proceeds to step S906. Alternatively, when it is determined that the searching has been performed the predetermined number of times, the process proceeds to step S906.

In step S906, the proposal apparatus 180 outputs the kneading condition for search determined to satisfy the predetermined condition, as a searched-out kneading condition.

In step S907, when there are multiple searched-out kneading conditions, the proposal apparatus 180 selects one kneading condition.

In step S908, the kneader 130 kneads a fluororesin and a filler under the searched-out kneading condition, to manufacture a solid composition.

In step S909, the evaluation apparatuses 151 and 152 evaluate the linear expansion coefficient and the dielectric properties of the manufactured solid composition, respectively.

In step S910, the proposal apparatus 180 determines whether or not the linear expansion coefficient and the dielectric properties of the manufactured solid composition satisfy the target linear expansion coefficient and the target dielectric properties, respectively. When it is determined in step S910 that the linear expansion coefficient of the manufactured solid composition does not satisfy the target linear expansion coefficient, and when there are multiple searched-out kneading conditions and there still remains a kneading condition under which a solid composition has not been manufactured yet, the process returns to step S907. Alternatively, when it is determined in step S910 that the dielectric properties of the manufactured solid composition do not satisfy the target dielectric properties, and when there are multiple searched-out kneading conditions and there still remains a kneading condition under which a solid composition has not been manufactured yet, the process returns to step S907.

On the other hand, when it is determined in step S910 that the linear expansion coefficient and the dielectric properties of the manufactured solid composition satisfy the target linear expansion coefficient and the target dielectric properties, respectively, the process ends. Alternatively, when there are multiple searched-out kneading conditions and it is determined that solid compositions have been manufactured under all of these kneading conditions, the process ends.

As is clear from the foregoing description, the proposal apparatus 180 according to the first embodiment includes the controller configured to propose a kneading condition for manufacturing a solid composition containing a fluororesin and a filler. The controller is configured to:

- input a kneading condition for search into a trained model trained by using training data including a kneading condition for training, and an index value related to a linear expansion coefficient and a dielectric property of a solid composition manufactured under the kneading condition for training, to thereby output a predicted index value; and
- optimize the kneading condition for search based on the predicted index value and a target index value, and output the kneading condition optimized.

Thus, according to the proposal apparatus 180 according to the first embodiment, it is possible to search for a kneading condition that satisfies the target linear expansion coefficient and the target dielectric properties.

Examples

Hereinafter, the present invention will be described more specifically based on Examples. However, the present invention is not limited to the following Examples.

(Example 1)

Fifty three parts by mass of a tetrafluoroethylene/perfluoro(alkyl vinyl ether) copolymer (PFA) (Neoflon PFA AP Series, product number: AP-230SH, obtained from Daikin Industries, Ltd., having a linear expansion coefficient of 200 ppm/°C at 20°C to 200°C) as a fluororesin, and fibrous silica (Silica Chopped Fiber KSF-3N, obtained from Kowa Co., Ltd., having a fiber diameter of 7.5 μm, a fiber length of 3 mm, and an aspect ratio of 400) as a fibrous anisotropic filler were melt-kneaded using a tabletop kneader (apparatus name: MC15, obtained from Xplore Instruments BV) under the conditions of a kneading rotational speed of 50 rpm, a kneading temperature of 360°C, and a kneading time of 5 minutes, to manufacture a sheet-like solid composition of Example 1.

<Evaluation>

<<Linear Expansion Coefficient and Reduction Ratio of Linear Expansion Coefficient>>

The linear expansion coefficient of the obtained solid composition at 20°C to 200°C, and the reduction ratio (hereinafter, it may be referred to as the rate of decrease of the linear expansion coefficient) of the linear expansion coefficient of the solid composition at 20°C to 200°C to the linear expansion coefficient of the fluororesin at 20°C to 200°C were evaluated according to the following procedures.

First, as a sample, a sheet having an average thickness of 25 μm was formed from the obtained solid composition, and the linear expansion coefficient of the solid composition at 20°C to 200°C was measured using a thermomechanical analyzer (EXSTAR6000TMA/SS6000, obtained from SII Nanotechnology Inc.) under the following measurement conditions, and evaluated. The result is shown in Table 1.

--Measurement Conditions--

Step 1: Temperature was raised to 150°C at a temperature raising rate of 5°C/min to remove adsorbed water from the sample.

Step 2: Air cooling to room temperature was performed at a temperature lowering rate of 5°C/min.

Step 3: Main measurement was performed at a temperature raising rate of 5°C/min.

The average linear expansion coefficient in the temperature range of 20°C to 200°C in the main measurement was calculated as the intended linear expansion coefficient of the solid composition.

In the same way, the linear expansion coefficient of the fluororesin at 20°C to 200°C was measured similarly, using a sheet having an average thickness of 25 μm formed from the fluororesin as a sample. Then, the linear expansion coefficient of the solid composition at 20°C to 200°C was divided by the linear expansion coefficient of the fluororesin at 20°C to 200°C, to calculate the reduction ratio of the linear expansion coefficient.

Linear expansion coefficient of the solid composition at 20°C to 200°C was evaluated based on the following evaluation criteria.

-Evaluation Criteria-

A: The linear expansion coefficient of the solid composition was 50 ppm/°C or less.
B: The linear expansion coefficient of the solid composition was greater than 50 ppm/°C.

Reduction ratio of the linear expansion coefficient was evaluated based on the following evaluation criteria.

-Evaluation Criteria-

A: The reduction ratio of the linear expansion coefficient was 50% or greater.
B: The reduction ratio of the linear expansion coefficient was less than 50%.

<<Relative Permittivity>>

The relative permittivity of the obtained solid composition was measured by the SPDR method (resonator method) using a vector network analyzer (E5063A, obtained from Keysight Technologies) at 25°C at 10 GHz using a sheet having an average thickness of 25 μm formed from the solid composition as a sample. The result is shown in Table 1.

-Evaluation Criteria-

A: The relative permittivity of the solid composition was 2.5 or less.

B: The relative permittivity of the solid composition was greater than 2.5.

(Comparative Example 1)

A solid composition of Comparative Example 1 was manufactured in the same manner as in Example 1 except that unlike in Example 1, spherical silica (spherical silica HS-311, obtained from NIPPON STEEL Chemical & Material Co., Ltd., having a median diameter $D_{50}$ of 2.2 μm, and an aspect ratio of 1) was used instead of fibrous silica, and was evaluated. The results are shown in Table 1.

[Table 1]

| | Type | Product No. | Ex. 1 | Comp. Ex. 1 |
|---|---|---|---|---|
| Fluororesin | PFA | AP-230SH | 53 | 53 |
| | Fibrous silica | KSF-3N (Aspect ratio: 400) | 47 | - |
| | Spherical silica | HS-311 (Aspect ratio: 1) | - | 47 |
| Evaluation result | Reduction ratio of linear expansion coefficient★ | Measured value [%] | 79 | 40 |
| | | Evaluation | A | B |
| | Linear expansion coefficient | Measured value [ppm/°C] | 43 | 120 |
| | | Evaluation | A | B |
| | Dielectric constant | Measured value [F/m] | 2.01 | 2.24 |
| | | Evaluation | A | A |
| *: Reduction ratio of the linear expansion coefficient of the solid composition at 20°C to 200°C to the linear expansion coefficient of the fluororesin at 20°C to 200°C | | | | |

This application claims priority to Japanese Patent Application No. 2024-070591, filed on April 24, 2024, and the contents of Japanese Patent Application No. 2024-070591 are incorporated herein by reference in their entirety by reference.

REFERENCE SIGNS LIST

100: processing system
130: kneader
151, 152: evaluation apparatus
170: training data
180: proposal apparatus
500: training unit
810: prediction unit
820: evaluation unit
830: optimization unit

**Claims**

1. A solid composition, comprising:

   a fluororesin; and
   an anisotropic filler having a fibrous shape,
   wherein a reduction ratio of a linear expansion coefficient of the solid composition at 20°C to 200°C to a linear expansion coefficient of the fluororesin at 20°C to 200°C is 50% or greater.

2. The solid composition according to claim 1, wherein an aspect ratio of the anisotropic filler having the fibrous shape is 100 or greater.

3. The solid composition according to claim 1 or 2, wherein a mass ratio (A/B) of the anisotropic filler (A) having the fibrous shape to the fluororesin (B) is 5/95 to 60/40.

4. The solid composition according to any one of claims 1 to 3, wherein the anisotropic filler having the fibrous shape is silica.

5. The solid composition according to any one of claims 1 to 4,

   wherein unstable end groups present at an end of a main chain of the fluororesin are less than 50 groups per $1\times10^6$ carbon atoms of the fluororesin, and
   the unstable end groups are at least one type selected from the group consisting of $-CF_2H$, -COF, -COOH, $-COOCH_3$, $-CONH_2$, and $-CH_2OH$.

6. The solid composition according to any one of claims 1 to 5, wherein the fluororesin is at least one type selected from the group consisting of polytetrafluoroethylene, tetrafluoroethylene/perfluoro(alkyl vinyl ether) copolymer, and tetrafluoroethylene/hexafluoropropylene copolymer.

7. The solid composition according to any one of claims 1 to 6, wherein a loss tangent of the solid composition at 25°C at 10 GHz is 0.003 or less.

8. The solid composition according to any one of claims 1 to 7, wherein the solid composition is a film or a sheet.

9. The solid composition according to any one of claims 1 to 8, wherein the solid composition is an insulating material for a circuit board.

10. The solid composition according to any one of claims 1 to 9, wherein a relative permittivity of the solid composition at 25°C at 10 GHz is 2.6 or less.

11. A circuit board, comprising:

    an insulating layer containing the solid composition of any one of claims 1 to 10; and
    a conductive layer.

12. The circuit board according to claim 11, wherein the conductive layer is a metal.

13. The circuit board according to claim 12, wherein the metal is copper.

14. The circuit board according to any one of claims 11 to 13, wherein a surface roughness Rz of a surface of the conductive layer on a side of the solid composition is 2.0 μm or less.

15. The circuit board according to any one of claims 11 to 14, wherein the circuit board is a printed circuit board, a laminated circuit board, or a highfrequency board.

**16.** A method of manufacturing the solid composition of any one of claims 1 to 10, the method comprising: melt-kneading the fluororesin and the anisotropic filler to obtain the solid composition.

**17.** A proposal apparatus (180), comprising

a controller configured to propose a kneading condition for manufacturing a solid composition containing a fluororesin and a filler,
wherein the controller is configured to:

input the kneading condition for search into a trained model trained by using training data including the kneading condition for training, and an index value related to a linear expansion coefficient and a dielectric property of the solid composition manufactured under the kneading condition for training, to thereby output a predicted index value; and
optimize the kneading condition for search based on the predicted index value and a target index value, and output the kneading condition optimized.

**18.** The proposal apparatus (180) according to claim 17,
wherein the kneading condition includes information indicating a shape of the filler and information related to a blending ratio of the fluororesin and the filler.

**19.** The proposal apparatus (180) according to claim 18,
wherein the kneading condition includes a kneading rotational speed and a kneading time.

**20.** The proposal apparatus (180) according to claim 18 or 19,
wherein the information indicating the shape of the filler includes information indicating the shape of the filler that is a fibrous shape, information indicating the shape of the filler that is a spherical shape, and information indicating the shape of the filler that is a plate-like shape.

**21.** The proposal apparatus (180) according to any one of claims 18 to 20,
wherein the information related to the blending ratio includes a mass of the filler having a fibrous shape, a mass of the filler having a spherical shape, and a mass of the filler having a plate-like shape, relative to a predetermined mass of the fluororesin.

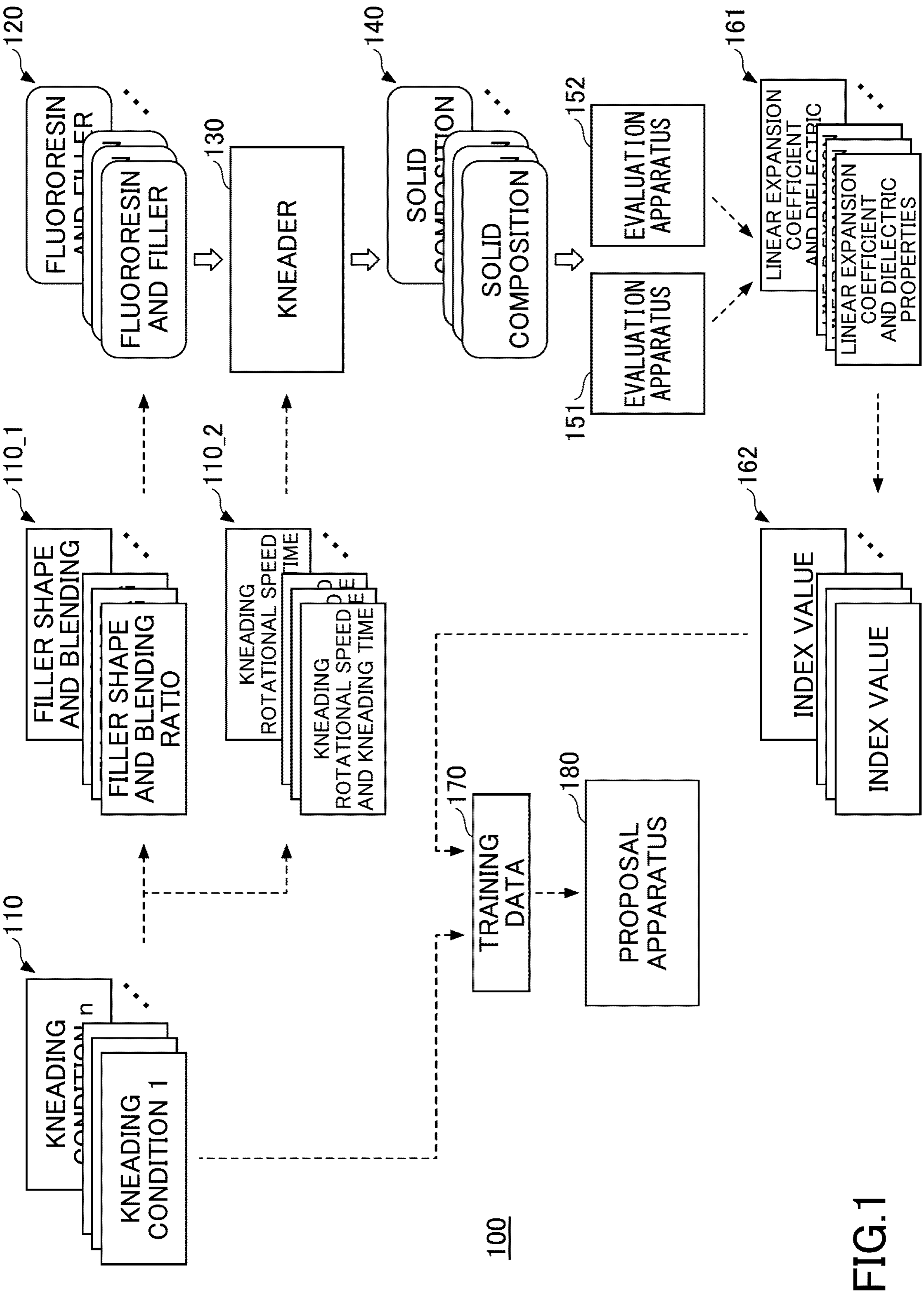
100
110
KNEADING CONDITION n
KNEADING CONDITION 1
110_1
FILLER SHAPE AND BLENDING
FILLER SHAPE AND BLENDING RATIO
110_2
KNEADING ROTATIONAL SPEED
TIME
KNEADING ROTATIONAL SPEED AND KNEADING TIME
120
FLUORORESIN AND FILLER
FLUORORESIN AND FILLER
130
KNEADER
140
SOLID COMPOSITION
SOLID COMPOSITION
151
EVALUATION APPARATUS
152
EVALUATION APPARATUS
161
LINEAR EXPANSION COEFFICIENT AND DIELECTRIC
LINEAR EXPANSION COEFFICIENT AND DIELECTRIC PROPERTIES
162
INDEX VALUE
INDEX VALUE
170
TRAINING DATA
180
PROPOSAL APPARATUS

FIG.1

FIG.2

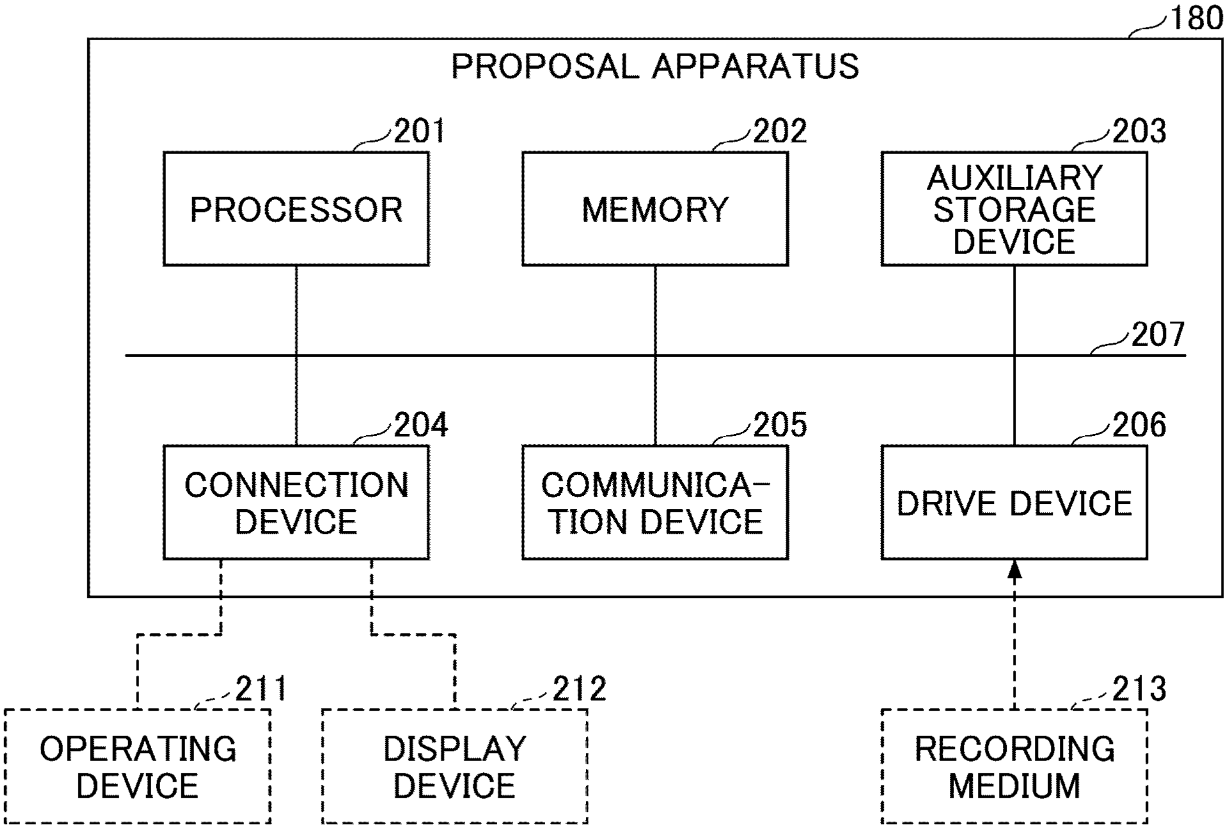
180
PROPOSAL APPARATUS
201
PROCESSOR
202
MEMORY
203
AUXILIARY STORAGE DEVICE
207
204
CONNECTION DEVICE
205
COMMUNICA-TION DEVICE
206
DRIVE DEVICE
211
OPERATING DEVICE
212
DISPLAY DEVICE
213
RECORDING MEDIUM

FIG.3

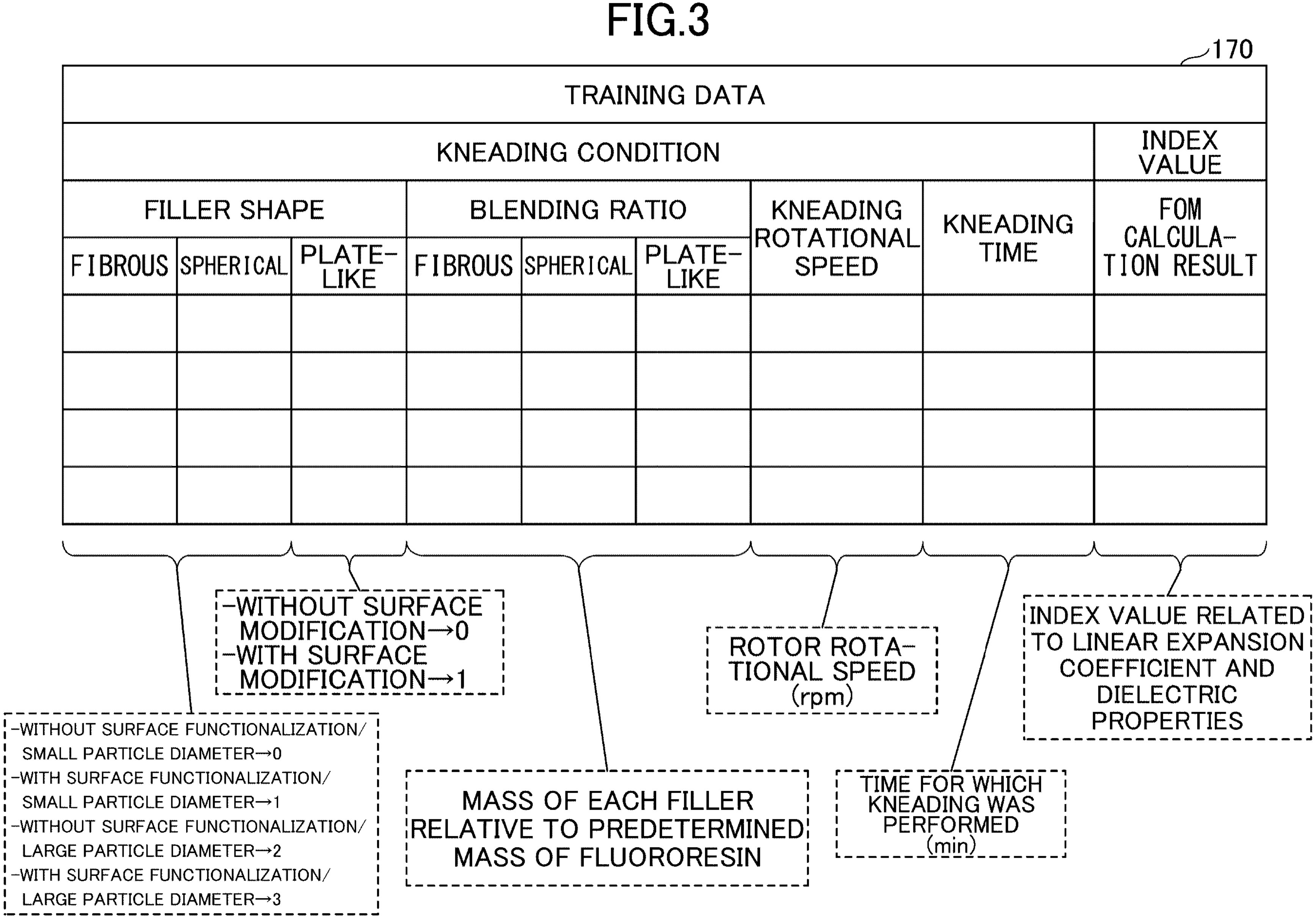
170
TRAINING DATA
KNEADING CONDITION
INDEX VALUE
FILLER SHAPE
BLENDING RATIO
KNEADING ROTATIONAL SPEED
KNEADING TIME
FOM CALCULA-TION RESULT
FIBROUS
SPHERICAL
PLATE-LIKE
FIBROUS
SPHERICAL
PLATE-LIKE
-WITHOUT SURFACE MODIFICATION→0
-WITH SURFACE MODIFICATION→1
-WITHOUT SURFACE FUNCTIONALIZATION/ SMALL PARTICLE DIAMETER→0
-WITH SURFACE FUNCTIONALIZATION/ SMALL PARTICLE DIAMETER→1
-WITHOUT SURFACE FUNCTIONALIZATION/ LARGE PARTICLE DIAMETER→2
-WITH SURFACE FUNCTIONALIZATION/ LARGE PARTICLE DIAMETER→3
MASS OF EACH FILLER RELATIVE TO PREDETERMINED MASS OF FLUORORESIN
ROTOR ROTA-TIONAL SPEED (rpm)
TIME FOR WHICH KNEADING WAS PERFORMED (min)
INDEX VALUE RELATED TO LINEAR EXPANSION COEFFICIENT AND DIELECTRIC PROPERTIES

FIG.4

FOM FORMULA

$$FOM = (x_{max} - x)/x_{_range} - (y - y_{min})/y_{_range}$$

$x_{_range}, y_{_range}$: VARIATION RANGE

$y_{min}$: DIELECTRIC PROPERTIES OF FLUORORESIN

$x_{max}$: LINEAR EXPANSION COEFFICIENT OF FLUORORESIN

FIG.5

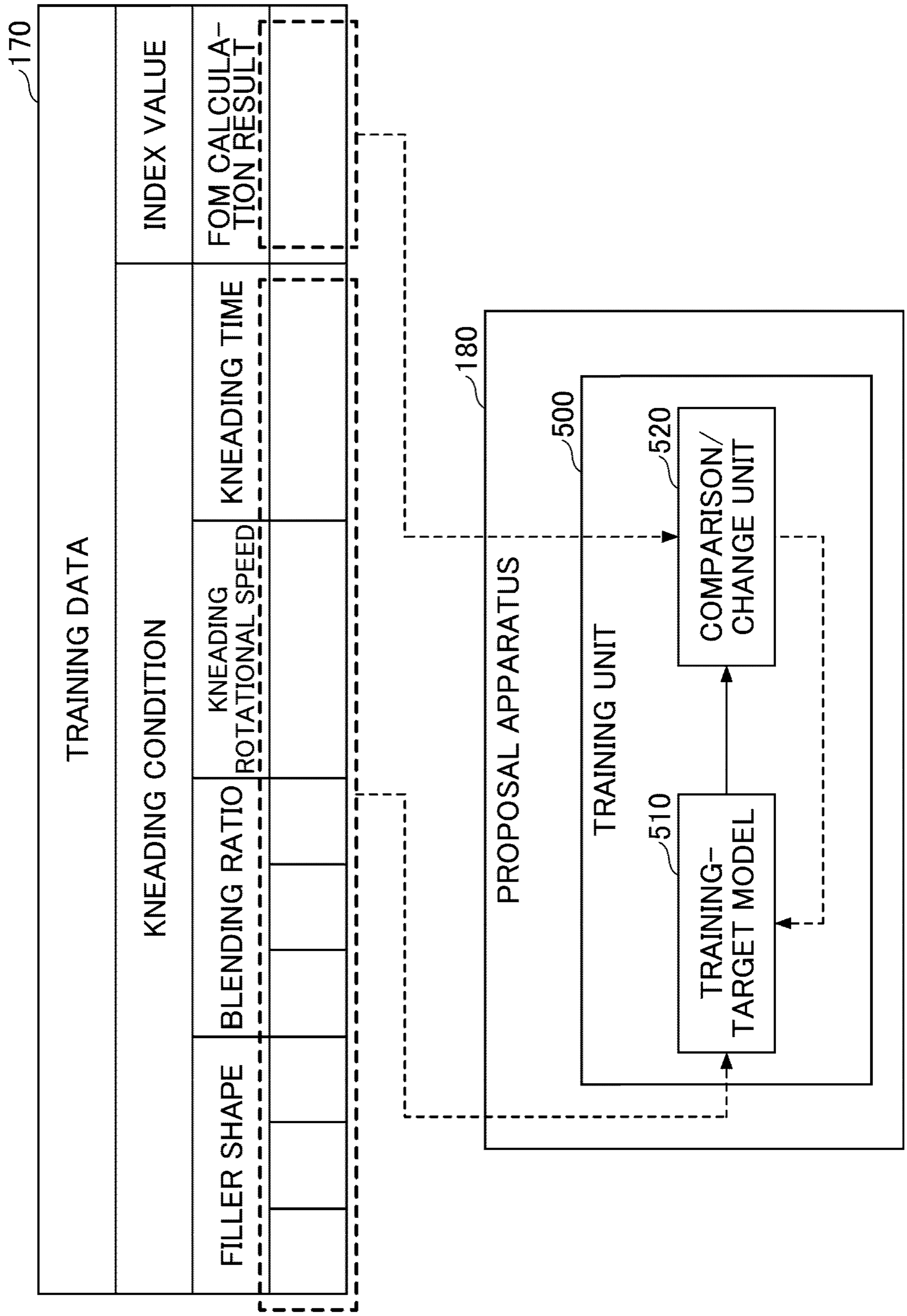
170
TRAINING DATA
KNEADING CONDITION
INDEX VALUE
FILLER SHAPE
BLENDING RATIO
KNEADING ROTATIONAL SPEED
KNEADING TIME
FOM CALCULA-TION RESULT
180
PROPOSAL APPARATUS
500
TRAINING UNIT
510
TRAINING-TARGET MODEL
520
COMPARISON/CHANGE UNIT

FIG.6

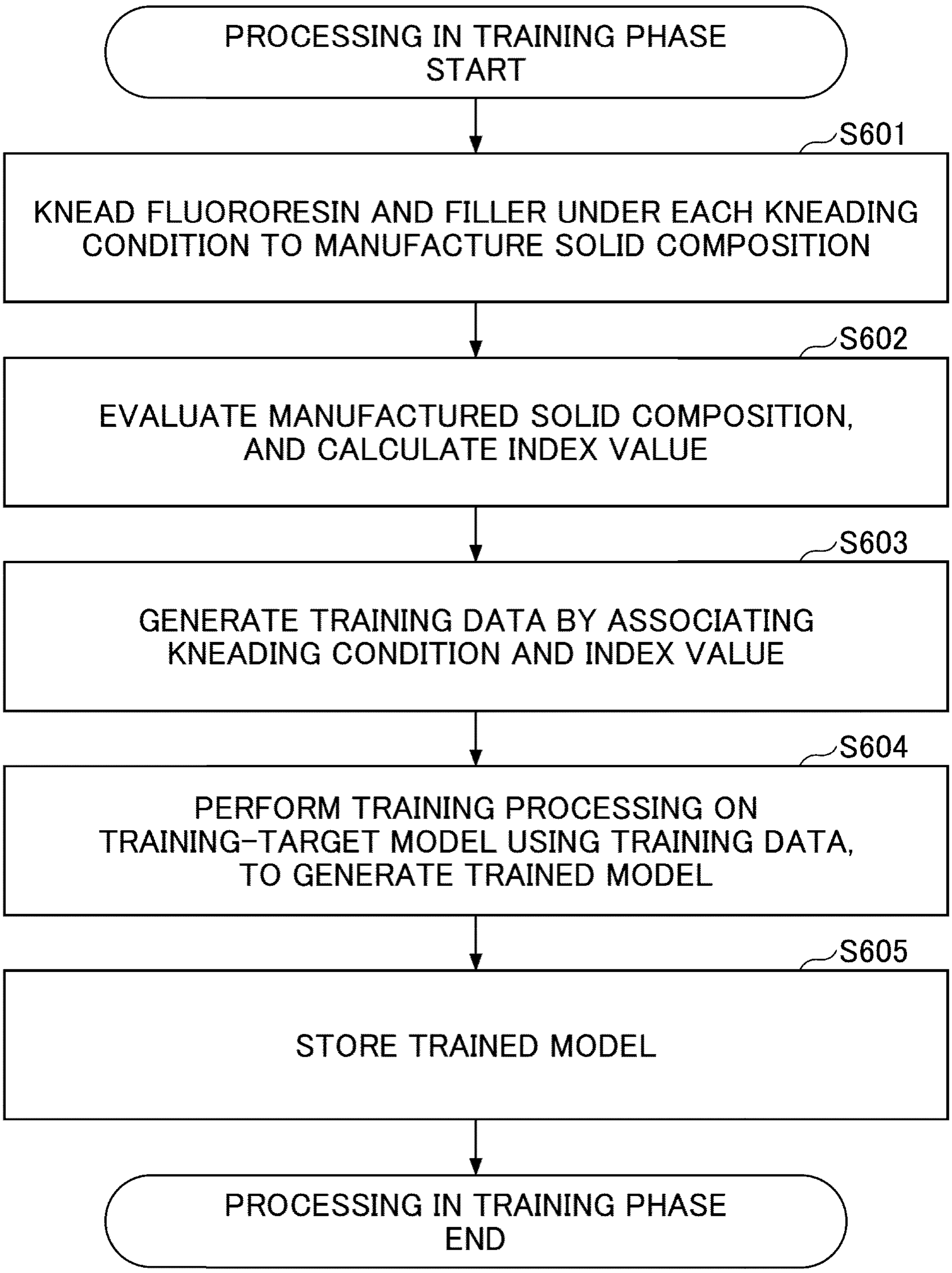
PROCESSING IN TRAINING PHASE START
S601
KNEAD FLUORORESIN AND FILLER UNDER EACH KNEADING CONDITION TO MANUFACTURE SOLID COMPOSITION
S602
EVALUATE MANUFACTURED SOLID COMPOSITION, AND CALCULATE INDEX VALUE
S603
GENERATE TRAINING DATA BY ASSOCIATING KNEADING CONDITION AND INDEX VALUE
S604
PERFORM TRAINING PROCESSING ON TRAINING-TARGET MODEL USING TRAINING DATA, TO GENERATE TRAINED MODEL
S605
STORE TRAINED MODEL
PROCESSING IN TRAINING PHASE END

FIG. 7

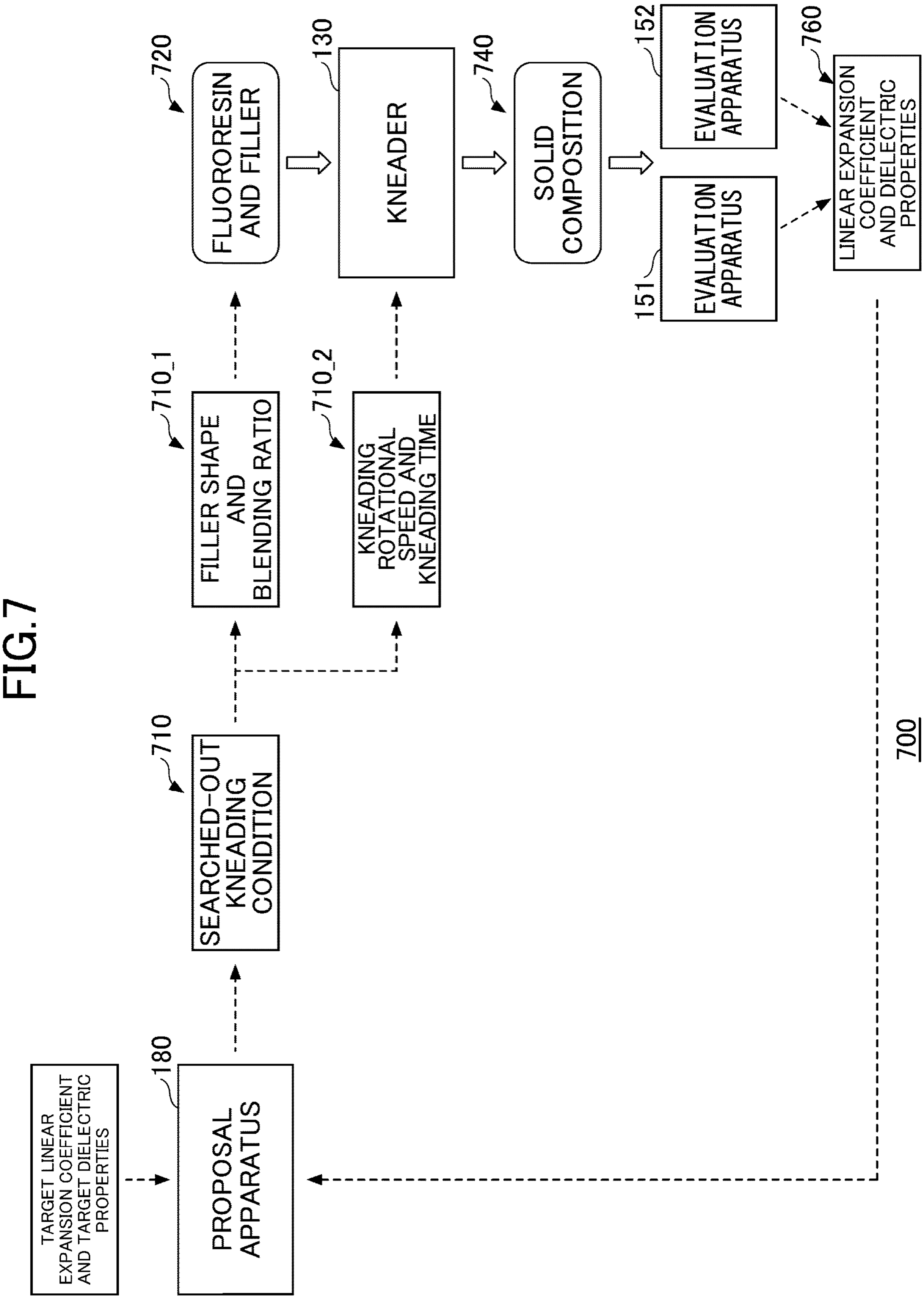
TARGET LINEAR EXPANSION COEFFICIENT AND TARGET DIELECTRIC PROPERTIES
PROPOSAL APPARATUS
180
SEARCHED-OUT KNEADING CONDITION
710
FILLER SHAPE AND BLENDING RATIO
710_1
KNEADING ROTATIONAL SPEED AND KNEADING TIME
710_2
FLUORORESIN AND FILLER
720
KNEADER
130
SOLID COMPOSITION
740
EVALUATION APPARATUS
151
EVALUATION APPARATUS
152
LINEAR EXPANSION COEFFICIENT AND DIELECTRIC PROPERTIES
760
700

FIG.8

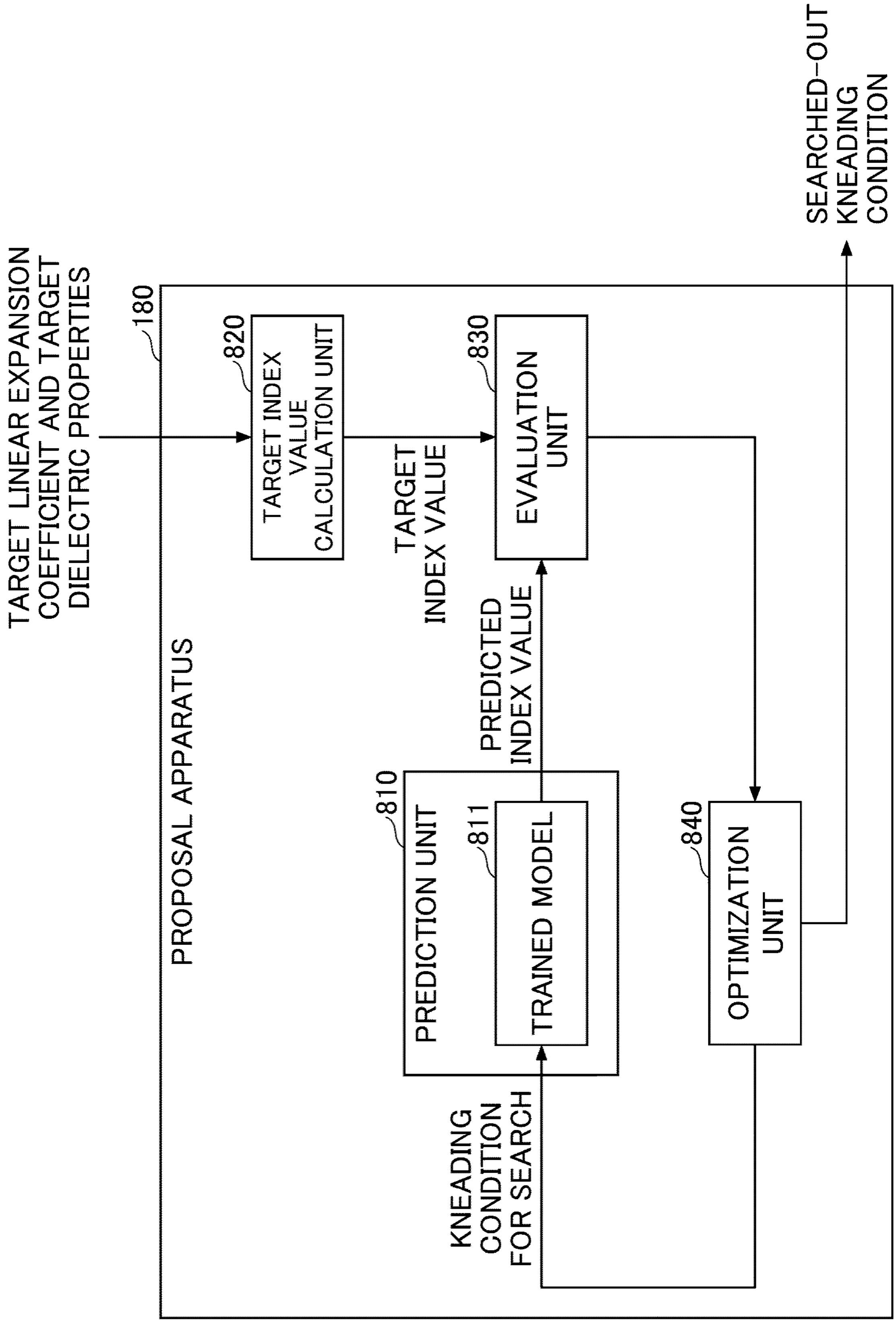
TARGET LINEAR EXPANSION COEFFICIENT AND TARGET DIELECTRIC PROPERTIES
180
PROPOSAL APPARATUS
820
TARGET INDEX VALUE CALCULATION UNIT
TARGET INDEX VALUE
830
EVALUATION UNIT
PREDICTED INDEX VALUE
810
PREDICTION UNIT
811
TRAINED MODEL
KNEADING CONDITION FOR SEARCH
840
OPTIMIZATION UNIT
SEARCHED-OUT KNEADING CONDITION

FIG.9

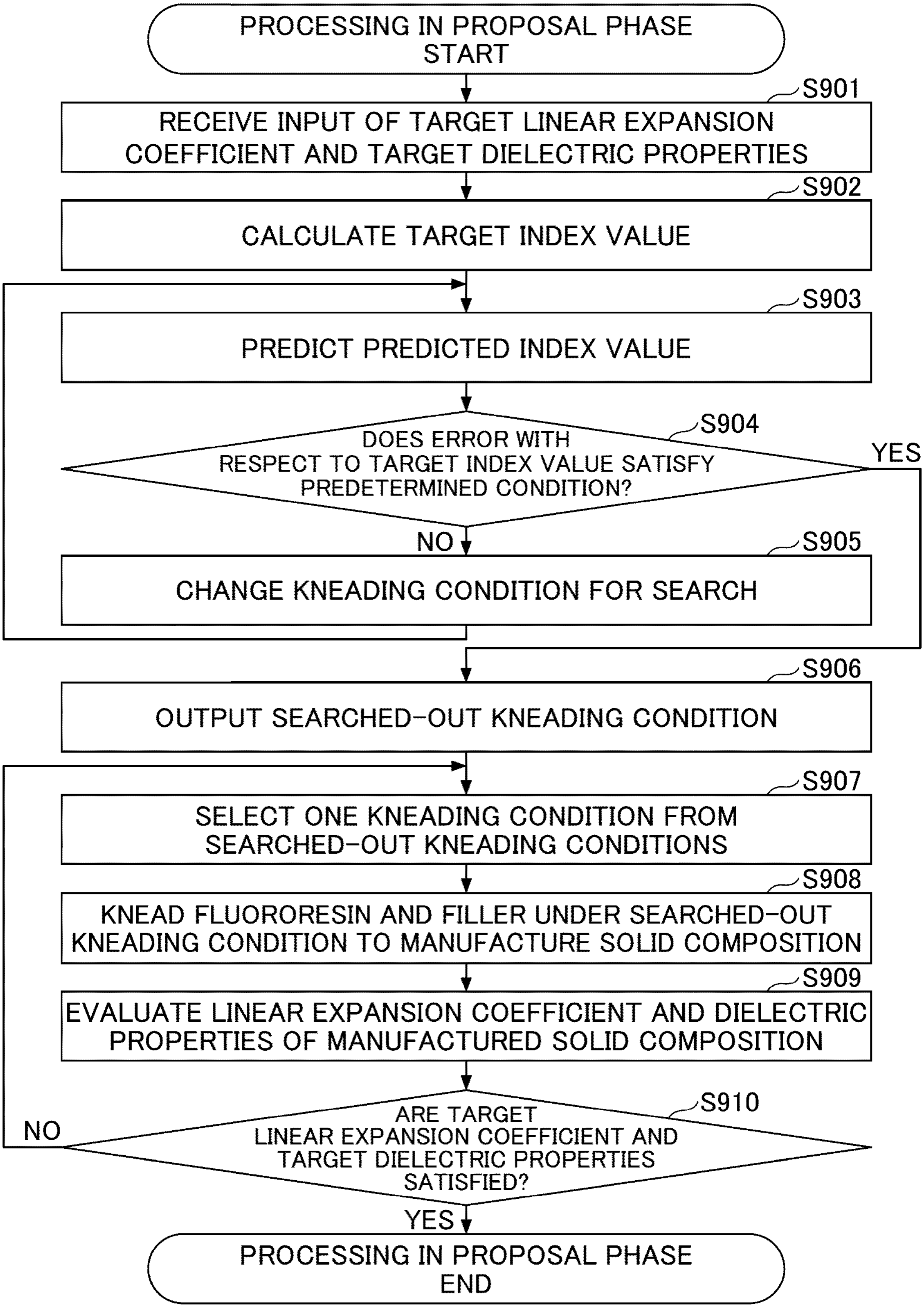
PROCESSING IN PROPOSAL PHASE START
S901
RECEIVE INPUT OF TARGET LINEAR EXPANSION COEFFICIENT AND TARGET DIELECTRIC PROPERTIES
S902
CALCULATE TARGET INDEX VALUE
S903
PREDICT PREDICTED INDEX VALUE
S904
DOES ERROR WITH RESPECT TO TARGET INDEX VALUE SATISFY PREDETERMINED CONDITION?
YES
NO
S905
CHANGE KNEADING CONDITION FOR SEARCH
S906
OUTPUT SEARCHED-OUT KNEADING CONDITION
S907
SELECT ONE KNEADING CONDITION FROM SEARCHED-OUT KNEADING CONDITIONS
S908
KNEAD FLUORORESIN AND FILLER UNDER SEARCHED-OUT KNEADING CONDITION TO MANUFACTURE SOLID COMPOSITION
S909
EVALUATE LINEAR EXPANSION COEFFICIENT AND DIELECTRIC PROPERTIES OF MANUFACTURED SOLID COMPOSITION
S910
ARE TARGET LINEAR EXPANSION COEFFICIENT AND TARGET DIELECTRIC PROPERTIES SATISFIED?
NO
YES
PROCESSING IN PROPOSAL PHASE END

# INTERNATIONAL SEARCH REPORT

International application No.
**PCT/JP2025/015625**

**A. CLASSIFICATION OF SUBJECT MATTER**

***C08L 27/12***(2006.01)i; ***C08J 5/18***(2006.01)i; ***C08K 3/36***(2006.01)i; ***C08K 7/00***(2006.01)i; ***C08K 7/04***(2006.01)i; ***C08L 27/18***(2006.01)i; ***H05K 1/03***(2006.01)i
FI: C08L27/12; C08J5/18 CEW; C08K3/36; C08K7/00; C08K7/04; C08L27/18; H05K1/03 610H; H05K1/03 610S

According to International Patent Classification (IPC) or to both national classification and IPC

**B. FIELDS SEARCHED**

Minimum documentation searched (classification system followed by classification symbols)

C08L27/12; C08J5/18; C08K3/36; C08K7/00; C08K7/04; C08L27/18; H05K1/03

Documentation searched other than minimum documentation to the extent that such documents are included in the fields searched

Published examined utility model applications of Japan 1922-1996
Published unexamined utility model applications of Japan 1971-2025
Registered utility model specifications of Japan 1996-2025
Published registered utility model applications of Japan 1994-2025

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2023-056159 A (TEIJIN LIMITED) 19 April 2023 (2023-04-19) claims 1-6, paragraphs [0013], [0020], [0031], [0045], fig. 5, 8, example 1, comparative example 1 | 1-3, 6-16 |
| Y | | 4-5 |
| A | | 17-21 |
| Y | WO 2023/149429 A1 (ARISAWA SEISAKUSHO KK) 10 August 2023 (2023-08-10) paragraph [0058], examples 1-3 | 1-21 |
| Y | WO 2023/074765 A1 (DAIKIN INDUSTRIES, LTD.) 04 May 2023 (2023-05-04) examples 1-8 | 1-21 |
| Y | WO 2021/024883 A1 (AGC INC.) 11 February 2021 (2021-02-11) examples 1-2 | 1-21 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **02 June 2025** | **17 June 2025** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | <br>Telephone No. |

Form PCT/ISA/210 (second sheet) (July 2022)

**INTERNATIONAL SEARCH REPORT**

International application No.
**PCT/JP2025/015625**

**C. DOCUMENTS CONSIDERED TO BE RELEVANT**

| Category* | Citation of document, with indication, where appropriate, of the relevant passages | Relevant to claim No. |
|---|---|---|
| Y | WO 2024/075758 A1 (DAIKIN INDUSTRIES, LTD.) 11 April 2024 (2024-04-11) paragraph [0087], examples 1-8 | 1-21 |
| Y | JP 2005-163006 A (CHUNG YUAN CHRISTIAN UNIV) 23 June 2005 (2005-06-23) claims 1, 14, examples | 1-21 |
| Y | WO 2024/070018 A1 (JNC CORP.) 04 April 2024 (2024-04-04) claims 1-4, paragraphs [0010], [0040], [0054]-[0059], [0077] | 1-16 |
| Y | WO 2024/070017 A1 (JNC CORP.) 04 April 2024 (2024-04-04) claims 1-4, paragraphs [0011], [0044], [0058]-[0063], [0081] | 1-16 |
| Y | JP 2007-169587 A (SEKISUI CHEMICAL CO., LTD.) 05 July 2007 (2007-07-05) claims 1-9, paragraphs [0020], [0059], [0063], [0077] | 1-16 |
| Y | WO 2019/187725 A1 (DAIKIN INDUSTRIES, LTD.) 03 October 2019 (2019-10-03) claims 1-5, paragraphs [0006]-[0008], [0027], examples 1-8 | 5 |
| Y | JP 2020-158664 A (DAIKIN INDUSTRIES, LTD.) 01 October 2020 (2020-10-01) paragraph [0057] | 17-21 |
| Y | WO 2021/241473 A1 (AGC INC.) 02 December 2021 (2021-12-02) paragraph [0027] | 17-21 |
| Y | JP 2023-155181 A (DAIKIN INDUSTRIES, LTD.) 20 October 2023 (2023-10-20) paragraphs [0071]-[0072], [0095] | 17-21 |
| Y | JP 2023-127849 A (AGC INC.) 14 September 2023 (2023-09-14) paragraph [0028] | 17-21 |
| Y | WO 2021/256340 A1 (SHIN-ETSU POLYMER CO., LTD.) 23 December 2021 (2021-12-23) paragraphs [0022], [0048] | 17-21 |
| Y | WO 2020/090607 A1 (AGC INC.) 07 May 2020 (2020-05-07) paragraph [0041] | 17-21 |
| Y | JP 2008-013610 A (DU PONT MITSUI FLUOROCHEM CO., LTD.) 24 January 2008 (2008-01-24) paragraph [0050] | 17-21 |
| Y | CN 116373197 A (SUZHOU HENGZECHENG INTELLIGENT TECHNOLOGY CO., LTD.) 04 July 2023 (2023-07-04) claims 1-10 | 17-21 |
| Y | JP 2022-080700 A (DAIKIN INDUSTRIES, LTD.) 30 May 2022 (2022-05-30) claim 29 | 17-21 |
| Y | JP 2023-051839 A (TORAY INDUSTRIES, INC.) 11 April 2023 (2023-04-11) claims 1-14, paragraph [0068] | 17-21 |

Form PCT/ISA/210 (second sheet) (July 2022)

**INTERNATIONAL SEARCH REPORT**
**Information on patent family members**

International application No.
**PCT/JP2025/015625**

| Patent document cited in search report | Publication date (day/month/year) | Patent family member(s) | Publication date (day/month/year) |
|---|---|---|---|
| JP 2023-056159 A | 19 April 2023 | (Family: none) | |
| WO 2023/149429 A1 | 10 August 2023 | CN 118475649 A<br>KR 10-2024-0141256 A<br>TW 202336139 A | |
| WO 2023/074765 A1 | 04 May 2023 | US 2024/0268020 A1<br>examples 1-8<br>CN 118076692 A<br>KR 10-2024-0089096 A<br>TW 202332330 A | |
| WO 2021/024883 A1 | 11 February 2021 | US 2022/0145043 A1<br>examples 1-2<br>CN 114174415 A<br>KR 10-2022-0044718 A | |
| WO 2024/075758 A1 | 11 April 2024 | TW 202428759 A | |
| JP 2005-163006 A | 23 June 2005 | US 2005/0123739 A1<br>claims 1, 14, examples<br>TW 200523110 A | |
| WO 2024/070018 A1 | 04 April 2024 | (Family: none) | |
| WO 2024/070017 A1 | 04 April 2024 | (Family: none) | |
| JP 2007-169587 A | 05 July 2007 | (Family: none) | |
| WO 2019/187725 A1 | 03 October 2019 | US 2021/0024769 A1<br>claims 1, 4-5, paragraphs [0006]-[0008], [0030], examples 1-8<br>EP 3778723 A1<br>CN 111886284 A | |
| JP 2020-158664 A | 01 October 2020 | US 2022/0010131 A1<br>paragraphs [0080]-[0082]<br>WO 2020/196243 A1<br>EP 3950825 A1<br>KR 10-2021-0134721 A<br>CN 113631653 A<br>TW 202100659 A | |
| WO 2021/241473 A1 | 02 December 2021 | TW 202204508 A | |
| JP 2023-155181 A | 20 October 2023 | US 2025/0040043 A1<br>paragraphs [0132]-[0134], [0169]<br>TW 202402918 A<br>CN 119013345 A | |
| JP 2023-127849 A | 14 September 2023 | (Family: none) | |
| WO 2021/256340 A1 | 23 December 2021 | TW 202212469 A | |
| WO 2020/090607 A1 | 07 May 2020 | CN 113348208 A<br>TW 202033576 A | |
| JP 2008-013610 A | 24 January 2008 | (Family: none) | |
| CN 116373197 A | 04 July 2023 | (Family: none) | |
| JP 2022-080700 A | 30 May 2022 | (Family: none) | |
| JP 2023-051839 A | 11 April 2023 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2023155181 A
- WO 2021112164 A
- JP 2024070591 A